(19) Europäisches Patentamt
European Patent Office
Office européen des brevets

(11) **EP 4 092 749 A1**

(12) **EUROPEAN PATENT APPLICATION**

(43) Date of publication:
**23.11.2022 Bulletin 2022/47**

(21) Application number: **22159470.8**

(22) Date of filing: **01.03.2022**

(51) International Patent Classification (IPC):
*H01L 27/24* (2006.01)  *H01L 45/00* (2006.01)
*G06N 3/063* (2006.01)

(52) Cooperative Patent Classification (CPC):
**H01L 27/11507; G06N 3/063; H01L 27/2463;**
**H01L 27/2481; H01L 27/249; H01L 45/04;**
**H01L 45/1233; H01L 45/146; H01L 45/147;**
**H01L 45/1675;** G06N 3/0445; G06N 3/0454;
G06N 3/08; G06N 7/005

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **20.05.2021 US 202117326215**

(71) Applicant: **Intel Corporation**
**Santa Clara, CA 95054 (US)**

(72) Inventor: **Karpov, Elijah V.**
**Portland, 97229 (US)**

(74) Representative: **Goddar, Heinz J. et al**
**Boehmert & Boehmert**
**Anwaltspartnerschaft mbB**
**Pettenkoferstrasse 22**
**80336 München (DE)**

(54) **CROSS ARRAY FERROELECTRIC TUNNEL JUNCTION DEVICES FOR ARTIFICIAL INTELLIGENCE AND MACHINE LEARNING ACCELERATORS**

(57) A cross-point integrated circuit (IC) for an artificial neural network (ANN) includes a synaptic structure (100) formed from a plurality of wordlines (WLs; 112), a plurality of bitlines (BLs; 113), and a plurality of ferroelectric tunnel junctions (FTJs; 120) coupling a portion of a BL and a portion of a WL. Each synapse is configured to perform an ANN operation based on an input voltage applied to the plurality of WLs and output a current on a corresponding BL.

~100nm dot- higher resolution

**Figure 1**

**Description**

FIELD

Embodiments of the present disclosure generally relate to the field of electronics, and more particularly, to configurations, arrangements, operation, and fabrication of artificial intelligence and/or machine learning (AI/ML) hardware accelerators.

BACKGROUND

Artificial intelligence (AI) and/or Machine learning (ML) architectures are typically based on artificial neural networks (ANNs). ANNs, such as deep neural networks (DNNs), are currently used in numerous ML applications such as computer vision, speech recognition, robotics, among many others. ANNs are inspired by signal processes in biological neural networks. Biological neural networks are composed of a groups of chemically connected or functionally associated neurons. A single neuron may be connected to many other neurons. Neurons are connected to one another through connections referred to as "synapses." A synapse is a structure that permits a neuron to pass an electrical or chemical signal to another neuron. The total number of neurons and connections (synapses) and the density of neurons and synapses in a biological neural network may be quite extensive.

Conventional ANNs may run on AI/ML acceleration hardware (also referred to as "hardware accelerators" and the like). Hardware accelerators are computer hardware devices or electrical circuits specially tailored to perform a specific function more efficiently than using a general-purpose central processing unit (CPU). AI/ML acceleration hardware are specially-tailored to perform specific AI/ML functions. Current AI/ML hardware (HW) accelerators rely on conventional electronic components and architectures, such as complementary metal-oxide-semiconductor (CMOS) technology.

However, CMOS-based HW accelerators have relatively large synapses and neurons, which makes them impractical for providing sufficient synapse and/or neuron density for most modern AI/ML applications. In addition to taking up too much space inside the accelerator platform, CMOS-based HW accelerators consume relatively large amounts of energy when performing computations. Furthermore, CMOS-based HW accelerators tend to have relatively slow response times (e.g., when incorporated as a cloud solution), which makes them impractical for applications that have low latency requirements. This means that CMOS-based HW accelerators are impractical for use in cloud computing systems for applications requiring fast response and usually need to be local or relatively close in distance to a host machine. CMOS-based HW accelerators do not provide the neuron density and energy efficiency required to execute large ANN models by local AI/ML services.

BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.

Figure 1 depicts various views of an example variable resistance device according to various embodiments.
Figure 2 depicts an example process for fabricating an example variable resistance device according to various embodiments.
Figures 3, 4, and 5 show cross-sectional views of an example variable resistance device as particular fabrication operations are performed according to the process shown by Figure 2, in accordance with various embodiments.
Figures 6a, 6b, 7a, 7b, 8a, and 8b depict additional or alternative views of an example variable resistance device as particular fabrication operations are performed according to the process shown by Figure 2, in accordance with various embodiments.
Figure 9 depicts a top view of an example lateral 8 × 8 multi-terminal cross-point device according to various embodiments.
Figure 10 depicts ferroelectric tunnel junction (FTJ) properties according to various embodiments.
Figure 11 shows simulation results of FTJ devices according to various embodiments.
Figure 12 shows an example ferroelectric layer according to various embodiments.
Figure 13 depicts an example memristive crossbar array device according to various embodiments.
Figures 14, 15, and 16 depict perspective views of respective three-dimensional (3D) synaptic structure according to various embodiments.
Figure 17 depicts an example arrayed synaptic structure according to various embodiments.
Figure 18 illustrates an neural network (NN) example accelerator architecture according to various embodiments.

Figure 19 illustrates an example components of a computing system(s) according to various embodiments

DETAILED DESCRIPTION

Embodiments of the present disclosure describe configurations, arrangements, operation, and fabrication of hardware elements for operating artificial neural networks (ANNs), and in particular, for cross point ("x-point") and/or cross bar ("x-bar") array based on ferroelectric tunnel junction (FTJ) devices for artificial intelligence and/or machine learning (AI/ML) accelerator applications.

As mentioned previously, current AI/ML acceleration hardware architectures are CMOS-based and do are unable to provide synapse density and the energy efficiencies required to execute large AI/ML models, including cloud-based AI/ML models and locally executable AI/ML models. Cloud-based AI/ML models can solve relatively large problems using numerous servers in data centers and/or server farms, often using relatively large dedicated power sources. However, cloud-based AI/ML applications are not fast enough for real time applications. Real time applications cannot be supported by cloud-based AI/ML applications due to response time constraints. The cloud-based AI/ML applications also require very large, mainframe scale computer systems when the number of synapses required for specific AI/ML models is beyond one billion (i.e., $10^9$ or 1e9).

According to various embodiments, real time AI/ML model execution is possible by utilizing transistor-less synapses. In various embodiments, the transistor-less synapses are interconnected in a cross point (x-point) architecture because such systems can achieve synapse densities of one million million (i.e., $10^{12}$ or 1e12) in a 1 centimeter (cm) by 1cm space. In some embodiments, the x-point architecture may be constructed in a similar manner as the x-point architecture used for 3D Xpoint® and/or Optane® memory devices provided by Intel®, which means that fabrication of such devices may incur relatively little upfront costs and overhead. The embodiments herein make it possible to fabricate integrated circuits (ICs) with a number of synapses that are the same or similar to the number of the synapses in human brain. Other embodiments may be described and/or claimed.

## 1. EXAMPLE EMBODIMENTS

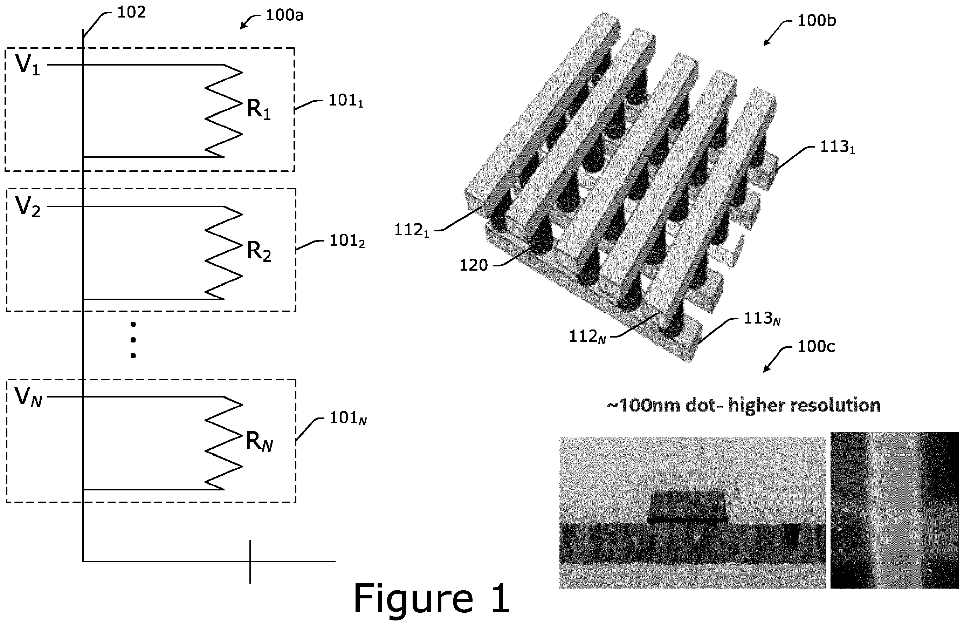

Figure 1 depicts different views (view 100a, 100b, and 100c) of a synaptic device 100 according to various embodiments. The synaptic device 100 (also referred to as a "variable resistance device 100") is configured to perform inference functionality and/or different operations for ML/AI applications. As examples, the synaptic device 100 can execute addition/summation, subtraction, multiplication, division, matrix operations, sum of multiplications (i.e., multiply and accumulate (MAC) operations), vector-by-matrix multiplication (VMM), and/or other operations. In the example of Figure 1, the synaptic device 100 comprises a plurality of synapses, each of which have variable resistances/conductances for performing multiply and accumulate (MAC) operations.

As shown by view 100a, the synaptic device 100 comprises a plurality of variable resistance circuit elements 101 (including circuit elements $101_1$ to circuit elements $101_N$, where N is a number). Each circuit element 101 includes a voltage (V) (e.g., $V_1$ to $V_N$) coupled to a respective resistor (R) (e.g., $R_1$ to $R_N$) in parallel with a common bit line 102. Application of the voltage V to each resistor R creates a conductance (6) that produces a current (I) (note that the conductance and current are not shown by Figure 1). Here, conductance 6 may be expressed as $6 = 1/R_i$ where i is a number from 1 to $N$. The current travels to a next circuit element 101 via the common bit line 102. In this way, the voltage is multiplied by the conductance 6 as the current I travels through each circuit element 101, and this current I is accumulated on the same line 102. Here, the sum of multiplications may be expressed as equation 1 or equation 2:

$$I = \sum (6) \cdot V_i, I = \sum \left(6_j\right) \cdot V_i \qquad \text{[Equation 1]}$$

$$I = \sum \sum \left(6_{ij}\right) \cdot V_{ij} \qquad \text{[Equation 2]}$$

In embodiments, the resistance $R_i$ of each FTJ can be controlled, and various input voltages may be applied to a string of FTJ-based devices. In one example, if each resistance $R_i$ is set to be the same, then summation and subtraction operation is enabled. Furthermore, the variable resistance device 100 can be used with forced current and measure voltages.

As shown by view 100b, the synaptic structure 100 comprises a x-point array/vector of voltage input lines 112 (e.g., elements $112_1$ to $112_N$, note that not all voltage input lines 112 are labelled in Figure 1) and output lines 113 (e.g., elements $113_1$ to $113_N$, note that not all output lines 113 are labelled in Figure 1). The voltage input lines 112 may also be referred to as resistance elements 112, wordlines (WLs) 112, or the like, and the output lines 113 may also be referred to as resistance elements 113, bitlines (BLs) 113, or the like. In this example, the input lines 112 and output lines 113 are laid out in a rectangular, grid or mesh pattern. When an input voltage is applied to the voltage input lines 112, the current flows is accumulated on each of the output lines 113, which will include some additional voltage and conductance in each of the devices along respective output lines 113. This allows the synaptic device 100 to not require any transistors, CMOS devices, silicon structures, and/or the like. In these ways, the synaptic device 100 provides at least an order of magnitude of density that is similar to DRAM and SRAM devices.

Additionally, the resistance elements 112 and the output lines 113 are coupled to one another via ferroelectric tunnel junctions (FTJs) 120 (note that not all FTJs 120 are labelled in Figure 1). View 110c shows an example of a fabricated variable resistance device 100 including a synaptic device in between crossed bars. The ferroelectric (FE) layer 120 (also referred to as the FTJ layer 120) at the cross-section of the crossing lines 112 and 113 enables the compute functionality. FTJs 120 are structures/devices in which an ultrathin layer of ferroelectric material is intercalated between two metallic electrodes. In FTJ devices, polarization reversal induces large modifications of the tunnel resistance, leading to a non-destructive readout of the information.

Although view 100b shows the variable resistance device 100 with a certain number of voltage input lines 111, resistance elements 112, output lines 113, and FTJs 120, the variable resistance device 100 may include any number of such elements than are shown by Figure 1.

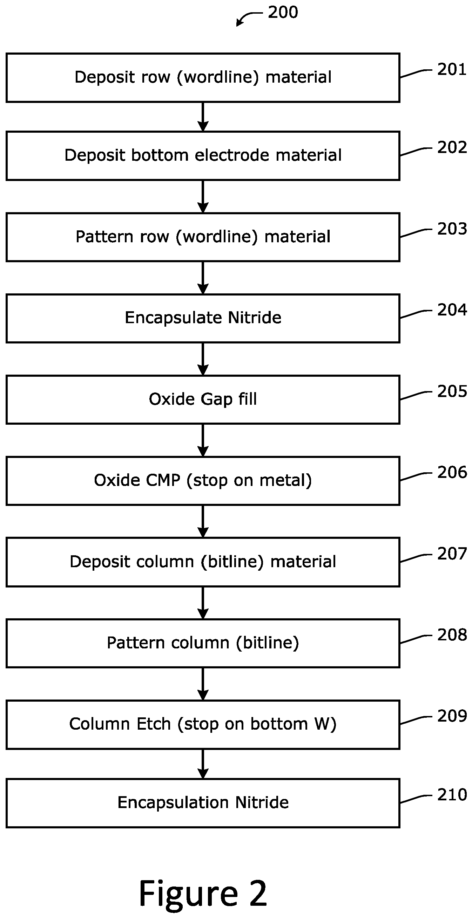

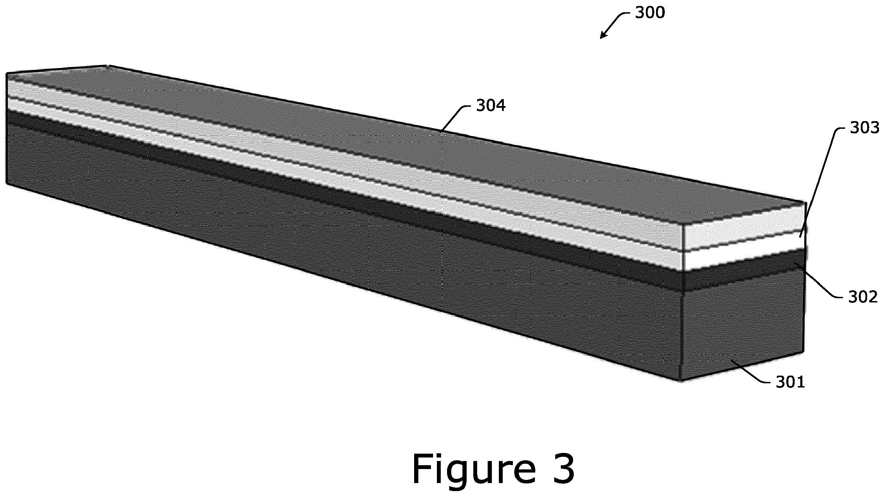

Figure 2 depicts an example process 200 for fabricating a variable resistance device according to various embodiments. Process 200 may be implemented to fabricate a variable resistance device 100 as shown by Figure 1, or any other ML/AI compute structures as discussed herein. In the illustrated implementation, process 200 includes operations 201-210, and Figures 3-5 illustrate the variable resistance device 100 subsequent to various operations 201-210, respectively. While particular examples and orders of operations are illustrated in Figures 3-5, in various embodiments, these operations may be re-ordered, broken into additional operations, combined, and/or omitted altogether without departing from the example embodiments disclosed herein. Furthermore, it should be noted that, because the variable resistance device 100 shown by Figures 1 and 3-5 is a 3D structure, the surfaces of the variable resistance device 100 may extend horizontally out of the plane shown by Figures 1 and 3-5 (e.g., into the page and/or out of the page). Moreover, the example embodiments shown and described with regard to Figures 3-5 may also apply to the surfaces of the semiconductor structure 100 that extend horizontally out of the plane shown by Figures 1 and 3-5.

Referring to Figures 2 and 3, process 200 may begin at operation 201, where a WL material 301 is deposited or formed on a substrate, wafer, wafer-level package, and/or some other suitable surface or material (not shown by Figures 3-5). Alternatively, the WL material 301 may be formed into a suitable WL or row structure 300 as shown by Figure 3. As examples, the WL material 301 may be copper (Cu), tungsten (W), Ruthenium (Ru), Cobalt (Co), tungsten nitride (WN), titanium nitride (TiN), and/or the like, and/or combinations thereof.

At operation 202, the FE layer is deposited on top of the WL material 301. In this example, operation 202 involves depositing a bottom electrode (BE) metal 302, active layer 303, and top electrode metal 304 stack are deposited on the WL material 301 *in situ*. In some embodiments, the active layer 303 may be formed from any material or combination of materials that are "active," meaning that its properties (e.g., its polarization) can be adjusted or altered. As examples, the active layer 303 may be a nitride (e.g., aluminium scandium materials such as $Al_xSc_{1-x}N$ and/or $Al_xSc_{1-x}O_2$ ($0.6 \leq x \leq 0.9$)) or a binary, ternary, or quaternary oxide (e.g., hafnium oxide ($HfO_2$), hafnium zirconium oxides ($Hf_xZr_{1-x}O_2$ ($0.3 \leq x \leq 0.5$), commonly referred to as "HZO" in the materials science arts), perovskites such as lead zirconate titanate ($Pb[Zr_xTi_{1-x}]O_3$ ($0 \leq x \leq 1$), commonly referred to as "PZT" in the materials science arts), barium titanate ($BaTiO_3$, commonly referred to as "BTO"), bismuth ferrite ($BiFeO_3$, commonly referred to as "BFO" in the materials science arts), , and/or the like, and/or combinations thereof. Additionally or alternatively, the FE layer (e.g., including layers 302, 303, and 304) may comprise a hafnium-zirconia ($HfZrO_2$) FE layer with an additional dielectric layer included such as a silicon dioxide ($SiO_2$) interfacial layer (IL) (sometimes referred to as an "interfacial dielectric layer" or the like).

At operation 203, the row (WL) structure 300 is patterned from the stack into the shape shown by Figure 3. The patterning process may include performing one or more suitable etch operations and/or one or more suitable photolithography operations as discussed herein. The dimensions (e.g., shape, length, width, thickness, etc.) of the row (WL) structure 300 may be application specific and/or may be chosen based on one or more design choices.

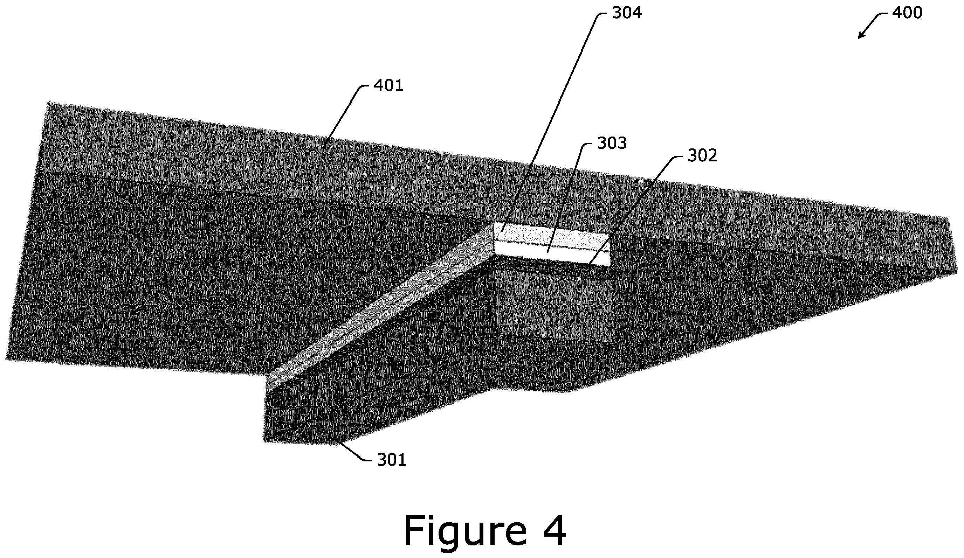

A result of operations 204, 205, 206, and 207 are shown by Figure 4. Referring to Figures 2 and 4, operation 204 includes encapsulating the row (WL) structure 300 with a nitride material. At operation 205, an oxide gap fill process is performed. In some embodiments, this may include using a gap-filling technology such as high-density plasma chemical vapor deposition (HDP-CVD) or the like. At operation 206, an oxide chemical mechanical planarization (CMP) is performed, which is performed until a metal layer is reached. Alternatively, another etching process may be performed, such as dry etch, or wet etch. At operation 207, BL material 401 deposition is performed in a same or similar manner as operation 201 discussed previously. The BL material 401 may be the same or similar as the WL material 301, or the BL material 401 may have a different composition than the WL material 301. The planarized structure 400 is produced as a result of performing operations 204, 205, 206, and 207.

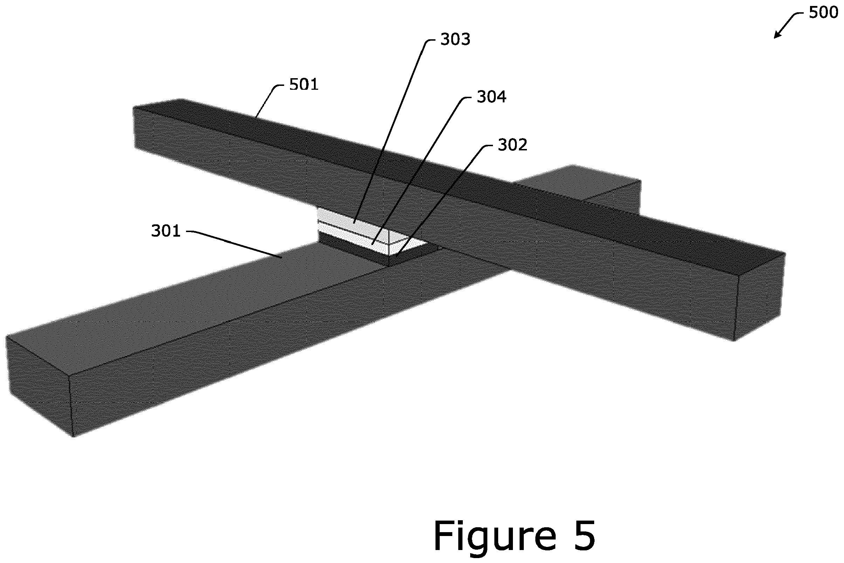

A result of operations 208, 209, and 210 are shown by Figure 5. Referring to Figures 2 and 5, operation 208 patterning column (BL) structure 501 from the structure 400 into column (BL) shape. The patterning may be performed in a same or similar manner as discussed previously with respect to operation 203, although the patterning is performed in an opposite direction than the patterning performed at operation 203. At operation 209, column etching is performed using a suitable etching process (such as those discussed previously) until the bottom WL material 301 is reached. At operation 210, a nitride encapsulation process is performed in a same or similar manner as discussed previously with respect to operation 204. The variable resistance structure 500 is produced as a result of performing operations 208, 209, and 210. The variable resistance structure 500 includes an FTJ device, which may comprise the layers 302, 303, and 304 in Figure 5. In other words, the FTJ device is two terminal device comprising a thin ferroelectric film sandwiched by two different electrodes (e.g., bottom electrode 301 and top electrode 501 in Figure 5). Process 200 may then be repeated as necessary to create multiple variable resistance structure 500, which may then be combined to form an array or matrix of variable resistance structures 500.

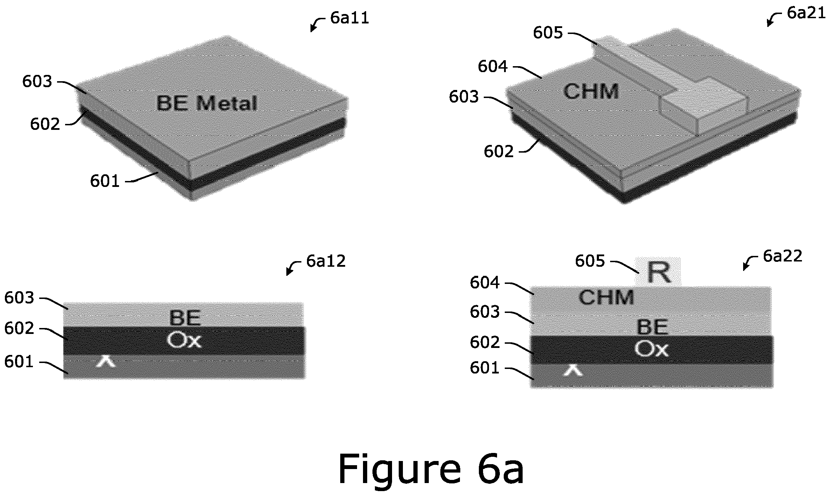

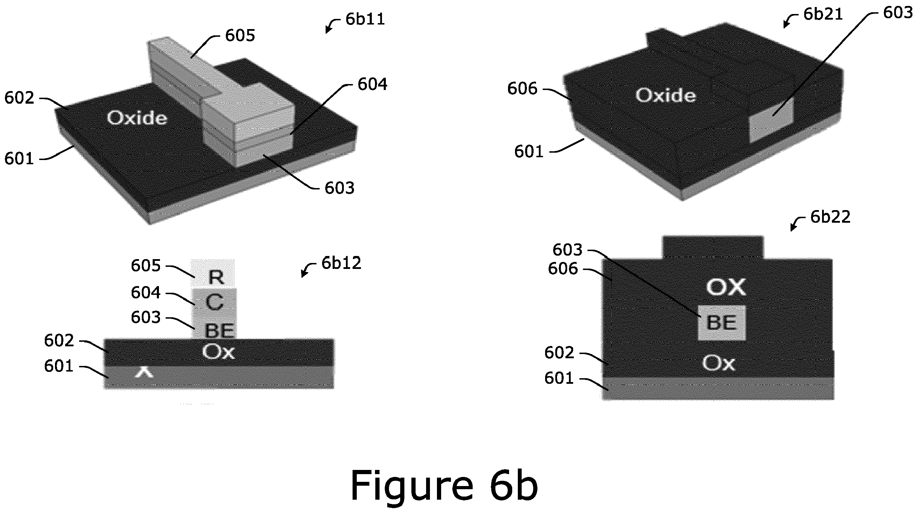

Figures 6a, 6b, 7a, 7b, 8a, and 8b depict additional or alternative views of an example fabrication sequence is performed in accordance with various embodiments. In particular, Figures 6a and 6b show examples of a bottom electrode (BE) patterning process. Referring to Figure 6a, the perspective view 6a11 and side/cross-section view 6a12 show the fabrication process after isolation oxide 602 and BE metal layer 603 deposition on a wafer or substrate 601. The BE metal layer 603 may correspond to the line material 301, 401 discussed previously. The perspective view 6a21 and side/cross-section view 6a22 show the fabrication process after carbon hard mask (CHM) 604 (patterning assist) deposition, resist (patterning) 605 deposition, and a lithography or etching process is performed to create the row (WL) structure 300. Referring to Figure 6b, the perspective view 6b11 and side/cross-section view 6b12 show the fabrication process after a subtractive dry etch of the CHM 604 and the BE metal layer 603. The perspective view 6b21 and side/cross-section view 6b22 show the fabrication process after the nitride 606 encapsulation. In alternative embodiments, an oxide material (e.g., same or similar to isolation oxide 602) may be used for encapsulation rather than the nitride 606.

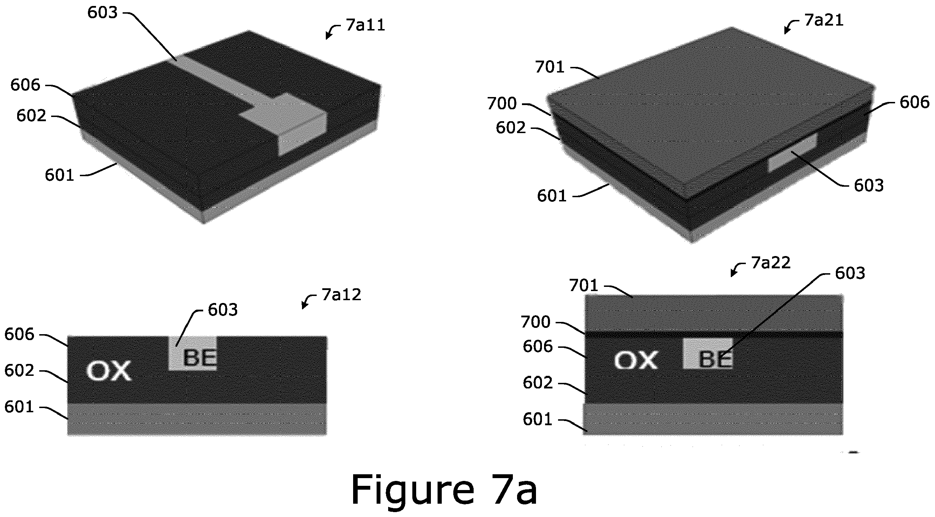

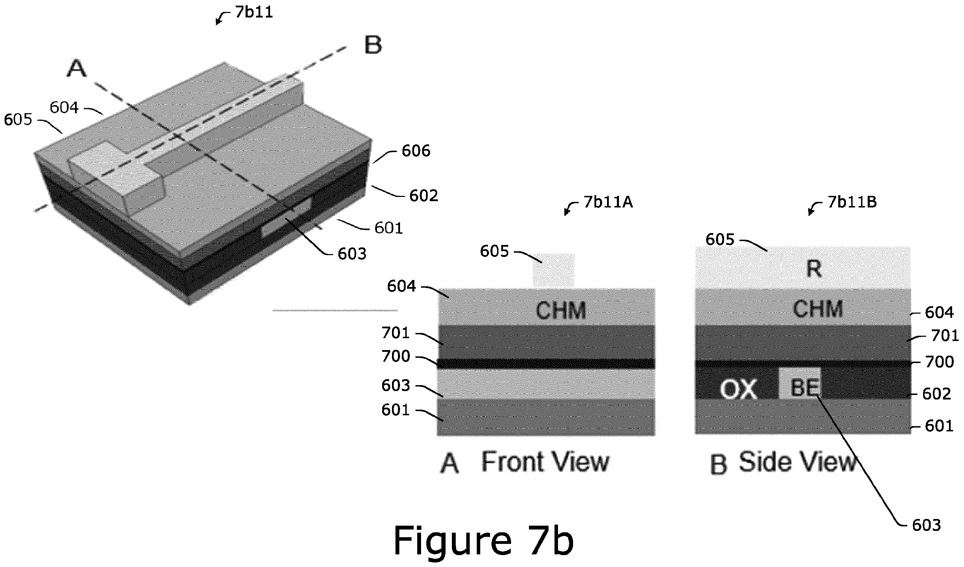

Figures 7a and 7b show examples of a top electrode (TE) patterning process. Referring to Figure 7a, the perspective view 7a11 and side/cross-section view 7a12 show the fabrication process after a shallow Trench Isolation (STI) CMP process to expose the BE metal layer 603 and a polish operation. The perspective view 7a21 and side/cross-section view 7a22 show the fabrication process after deposition of an active ferroelectric (FE) layer 700 and top electrode (TE) layer 701. The FE layer 700 may include an FE oxide or FE nitride layer with a relatively thin interfacial oxide layer. Referring to Figure 7b, the perspective view 7b11 shows the fabrication process after a CHM 604 (patterning assist) and resist (patterning) 605 deposition, and a top electrode patterning (etching) process. The view 7b11A shows a cross-section of the front view "A" of the perspective view 7b11, and the view 7b11B shows a cross-section from the side view "B" of the perspective view 7b11.

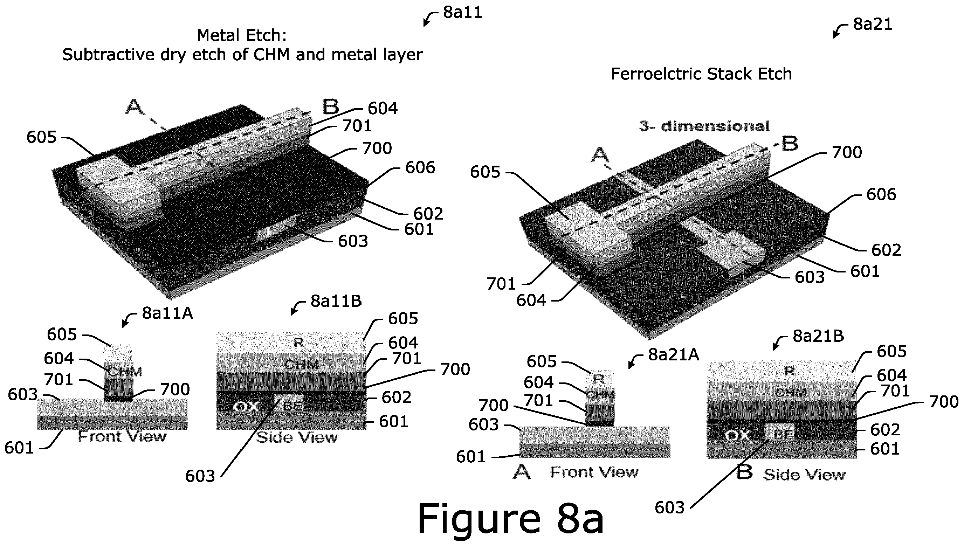

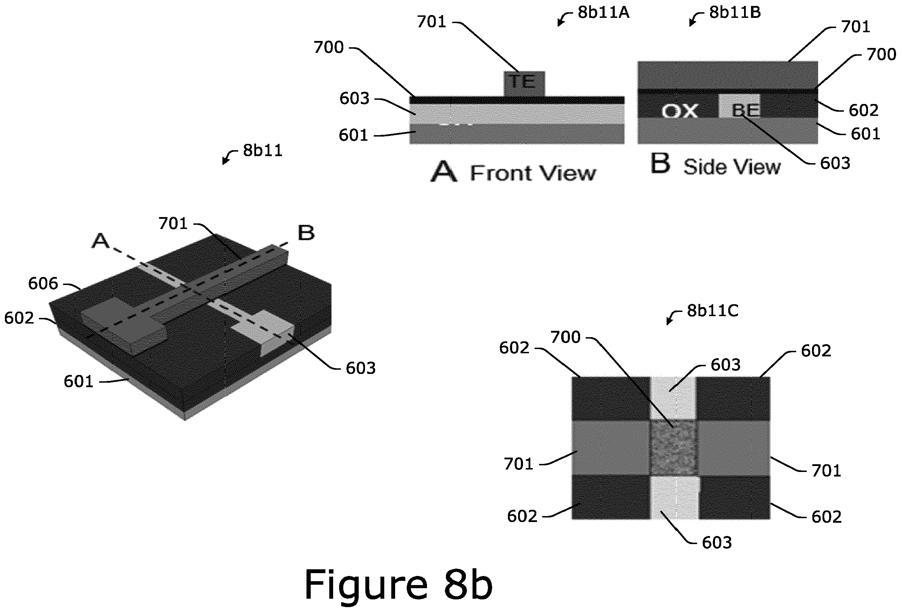

Figure 8a shows the fabrication process after various etching processes. In particular, view 8a11 shows the fabrication process after a metal etch process, which may be a subtractive dry etch of the resist 605, CHM 604, and the TE layer 701. The view 8a11A shows a cross-section of the front view "A" of the perspective view 8a11, and the view 8a11B shows a cross-section from the side view "B" of the perspective view 8a11. Figure 8a also includes view 8a21, which shows the fabrication process after etching the FE layer 700, The view 8a21 A shows a cross-section of the front view "A" of the perspective view 8a21, and the view 8a21B shows a cross-section from the side view "B" of the perspective view 8a21. Figure 8b shows the fabrication process after an ashing (e.g., plasma ashing) or other cleaning process. The view 8b11A shows a cross-section of the front view "A" of the perspective view 8b11, and the view 8b11B shows a cross-section from the side view "B" of the perspective view 8b11. The view 8b11C shows a top view of the perspective view 8b11. Note that the top view 8b11C shows the FE layer 700 at the overlap or intersection point between the TE layer 701 and the BE layer 602 for ease of understanding the exemplary embodiment. However, the FE layer 700 is disposed underneath the TE layer 701 and on top of the BE layer 602. Stated another way, the FE layer 700 is sandwiched between the TE layer 701 and the BE layer 602.

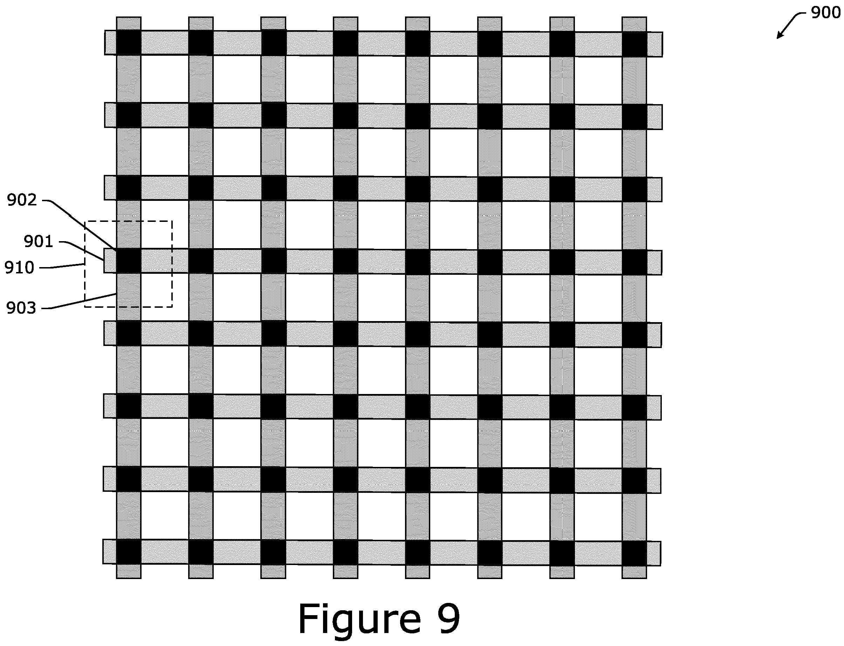

Figure 9 depicts a top view of a lateral 8 inputs x 8 outputs multi-terminal synaptic device 900 according to various embodiments. The synaptic device 900 includes a plurality of rows (WLs) 901, a plurality of columns (BLs) 903, and a plurality of FTJs 902 that are disposed at the intersection points of the rows (WLs) 901 and columns (BLs) 902. Each x-section or intersection point of a WL 901, BL 902, and FTJ 903 forms an individual synapse 910. The synaptic device 900 may be fabricated according to the embodiments discussed previously with respect to Figures 2-8b. Furthermore, the synaptic device 900 provides $4F^2$ compute density (where "F" is the half pitch, or the minimum dimensions needed to make an individual synapse).

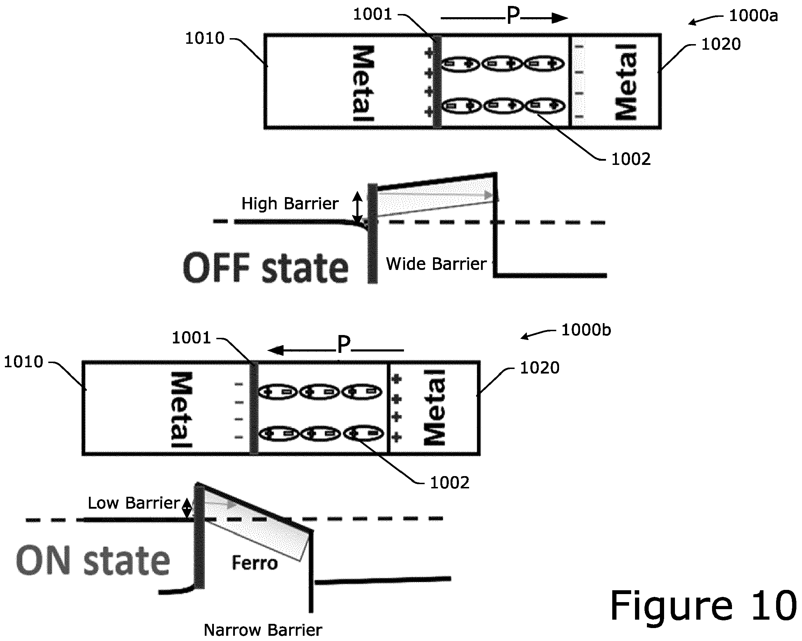

Figure 10 depicts FTJ properties, illustrating the conditions for On and Off states at low (read) field, according to various embodiments. As mentioned previously, FTJs may be disposed between the crossed lines (e.g., row (WLs) 901 and columns (BLs) 902). A capability of the x-point devices of the embodiments herein is low current operation for both for read and write operations. The FTJ device current depends on polarization of the ferroelectric layer 1001 as shown by Figure 10. Another capability of FTJ device is to have a high ratio of $I_{on}$ to $I_{off}$ currents possible and have tunable resistance range. These capabilities comes from the physics of transport illustrated in Figure 10.

For example, Figure 10 shows a ferroelectric (FE) layer 1001 sandwiched between two metal electrodes 1010 and 1020, where the ferroelectric layer 1001 includes dipoles 1002 of polarization vector P (note that not all dipoles 1002 are labeled in Figure 10). At the surface of an FE, polarization charges (e.g., dipoles 1002) are usually present and will repel or attract electrons, depending on their sign. This occurs over a short distance in the electrode beyond which the density of electrons resumes its normal value. The electrons near the interface screen the polarization charges. The Thomas-Fermi theory dictates that the screening length is a function of the electronic density of states at the Fermi level. For very good metals, the Thomas-Fermi screening length can be shorter than a tenth of nanometer, whereas for semiconductors it can reach tens of nanometers and screening is imperfect. The imperfect screening of polarization charges at the FE/electrode interface results in a distorted potential profile whose asymmetry and average height can depend on the polarization direction (> 0 when P points to the interface and < 0 when P points away from the interface). This is the main mechanism producing tunnel electroresistance in FTJ devices.

The polarization of vector P is controlled by an external voltage. Polarization switching driven by the external voltage causes a transition from the OFF state 1000a to the ON state 1000b, and/or vice versa. The polarization of the ferroelectric layer 1001 results in a different profile of a barrier for electrons to tunnel through the layers. In the OFF state 1000a, the polarization vector P is shown pointing in a rightward direction indicating that the polarization is from left to right, resulting in a high tunneling barrier height in the OFF state 1000a. By contrast, in the ON state 1000b, the polarization vector P is shown pointing in a leftward direction indicating that the polarization is from right to left, resulting in a low tunneling barrier height in the ON state 1000b.

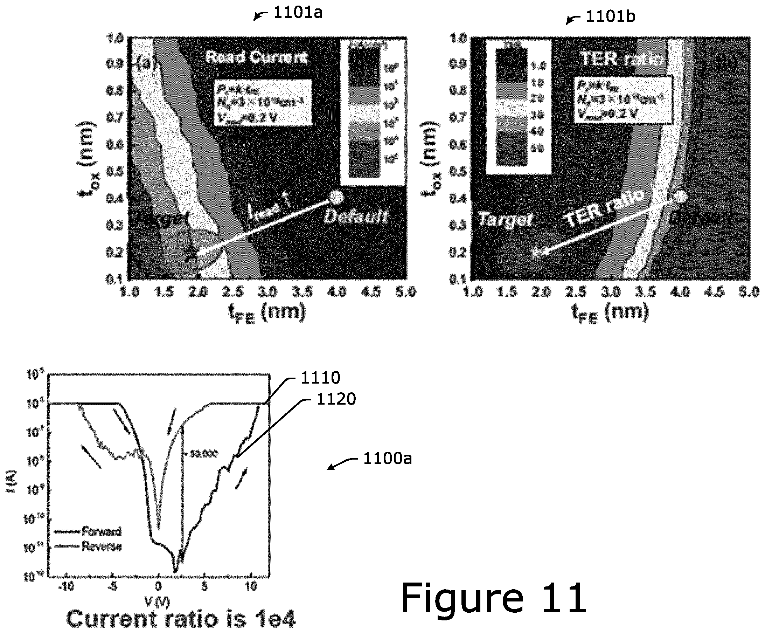

Figure 11 depicts results of operating an FTJ device according to various embodiments. The results shown by in Figure 11 are based on simulated operation of an FTJ device with a relatively thick FE layer, which have been shown to result in a relatively high voltage. In some cases, the amount or magnitude of the polarization vector that can be achieved by FTJ devices can be about 150 microcoulombs per square centimeter ($\mu C/cm^2$) can be achieved.

Graph 1100a shows Current-Voltage (I-V) characteristic curves for a forward direction 1110 and a reverse direction 1120, where the current is measured in Amps (A) and the voltage is measured in volts (V). The I-V ratio for the forward direction 1110 corresponds to the OFF state 1000a of Figure 10 (left to right direction) where the tunneling is unfavorable, and the current-to-voltage ratio for the reverse direction 1120 corresponds to the ON state 1000b of Figure 10 (right to left direction) where the tunneling is favorable. The current-to-voltage ratio for the reverse polarity 1120 is about 1e4. This shows that current ratio per synapse, which is a measure of how much each synapse can conduct in the FTJ synaptic device, and can vary quite significantly. Furthermore, because the $I_{on}$ is in the microamps range, this enables a low power operation. For example, a 0.1V for 100 kiloohms (k$\Omega$) resistor results in 1 $\mu A$ of current; 1 $\mu A$ of current in the read mode summed over 32 FTJ devices provides 32 $\mu A$; and 32 $\mu A$ over a 32 links long BL with up to 1 Ohm resistance results in ~1 millivolt (mV) parasitic voltage. The 1 mV of parasitic voltage over 100 k$\Omega$ of resistance results in 1/100 of 1 $\mu A$ of current is << of any read current specified. Another current-voltage (I-V) characteristic for the FTJ device is that the current for the polarization can be quite significant depending on the polarization direction (e.g., left to right 1000b or right to left 1000a). During operation, a spike in current occurs when the polarization is switched from a first direction to a second (opposite) direction, and then travels back downwards when the polarization is switched back to the previous direction. When the polarization switching takes place, the current changes substantially. This again demonstrates that the current through the FTJ device can be changed depending on whether the polarization switch takes place or not, and also shows that it's possible to switch the polarization from left to right 1000b and from right to left 1000a, numerous time. Furthermore, the polarization can affect the leakage current in the FE layer. For instance, the leakage current may appear to be much higher for positive fields than for negative fields. This is likely the source of the large discontinuity in the hysteresis.

Figure 11 also includes a graph 1101a showing a simulated contour plot of an ON-state current density ($J_{ON}$) versus IL thickness (tox) and FE thickness ($t_{FE}$) and graph 1101b showing a simulated contour plot of a tunneling electroresistance (TER) ratio versus tox and $t_{FE}$. The results shown by graphs 1101a and 1101b are based on a simulated Metal-Ferroelectric-Insulator-Semiconductor (MFIS) structure FTJ comprising a metal electrode, an $HfZrO_2$ FE layer, an $SiO_2$ interfacial layer (IL) and $N^+$ Si electrode. Various other aspects of this simulation are discussed in Mo et al., "Scalability Study on Ferroelectric-HfO2 Tunnel Junction Memory Based on Non-equilibrium Green Function Method", 2019 19th Non-Volatile Memory Technology Symposium (NVMTS), IEEE, pp. 1-5 (28 Oct. 2019), which is hereby incorporated by reference in its entirety. Graph 1101a shows a read current ($I_{read}$) versus tox and $t_{FE}$ wherein $I_{read}$ increases as $t_{FE}$ and tox are thinned down. Graph 1101b shows that the TER ratio becomes small due to a smaller remnant polarization ($P_r$) (here, $P_r$ is proportional to $t_{FE}$). However, TER ratio increases as tOX decreases, because of large band structure modulation due to more voltage drop on ferroelectric layer and semiconductor electrode as shown by graph 1101b. Graphs 1101a and 1101b demonstrate that modeling results can vary depending on how the FTJ device in a x-point device can be optimized for given design requirements. In particular, the lead current through a MFIS structure FTJ to a terminal device can be modified depending on the design parameters, such as thickness of the FE layer and/or the thin oxide layer in in contact with the FE layer (e.g., the IL).

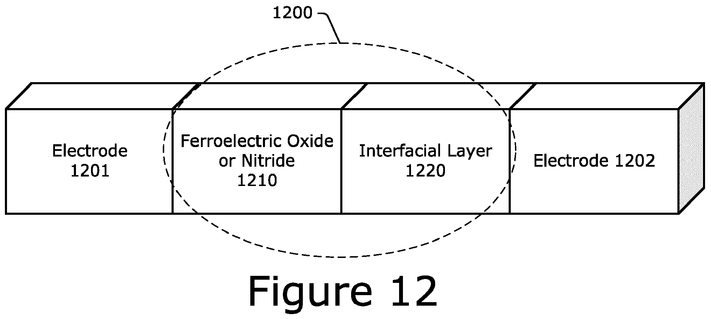

Figure 12 depicts an example FTJ device 1200 that can be used in a crossed array synaptic device, according to various embodiments. The FTJ device 1200 is coupled to electrode layers 1201 and 1202. In some examples, the electrode layers 1201 and 1202 correspond to the WL and BL layers 301 and 501 of Figure 5, respectively. In some embodiments, the electrode layers 1201 and 1202 may have a thickness between about 10 nanometers (nm) and about 200 nm, although the thickness of the electrode layers 1201 and 1202 may be outside this range in alternative embodiments, and/or may be application specific. Furthermore, the thicknesses of the electrode layers 1201 and 1202 may be the same as one another or may be different than one another. The electrode layers 1201 and 1202 may also be formed of a suitable conductive material such as Cu, W, Ru, Co, WN, TiN, an n-doped silicon material (e.g., $N^+$ Si), and/or some other suitable conductive material, and/or combinations thereof. In one example implementation, the electrode layer 1201 comprises one or more of Cu, W, Ru, Co, WN, and/or TiN, and the electrode layer 1202 is an $N^+$ Si electrode.

The FTJ device 1200 includes FE layer 1210 and IL layer 1220. The FE layer 1210 may be an oxide or a nitride material such as, for example, $HfO_2$, $HfZrO_2$, $Al_xSc_{1-x}N$ and/or $Al_xSc_{1-x}O_2$ ($0.6 \leq x \leq 0.9$), HZO, PZT, BTO, BFO, strontium titanate ($SrTiO_3$, commonly referred to as "STO" in the materials science arts), strontium ruthenate ($SrRuO_3$ and/or $SrRuO_4$, commonly referred to as "SRO" in the materials science arts), and/or some other suitable ferroelectric material and/or combinations thereof. The IL layer 1220 may be a suitable dielectric material such as $SiO_2$, silicon oxynitride ($SiO_xN_y$), silicon nitride ($Si_3N_4$), and/or high-k dielectric materials such as hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. Other materials and/or combinations of materials may be used in other embodiments. In some implementations, the IL layer 1220 may not be present in the FTJ device 1200. In some embodiments, the FTJ device 1100 may have a thickness of about 4nm to 20nm, although the thickness of the FTJ device 1100 may be outside this range in alternative embodiments, and/or may be application specific.

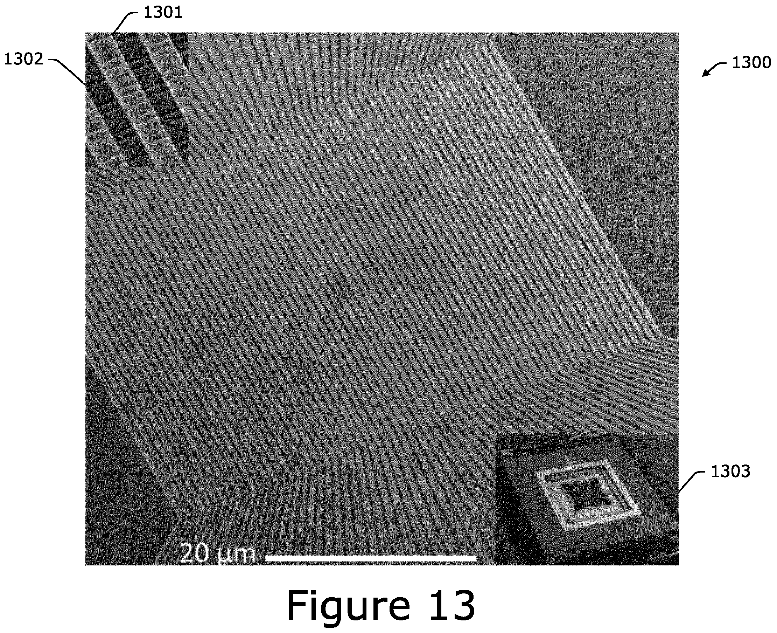

Figure 13 depicts a scanning electron microscope image of an example memristive device 1300 according to various embodiments. The memristive device 1300 is a fabricated $64 \times 64$ memristor crossbar array. The top inset shows a zoom-in view of a portion of the crossbar array including a BEs 1301 and TEs 1302. The bottom inset shows an example of a packaged chip 1303 that includes the memristive device 1300. Other aspects of the memristive device 1300 are discussed in Kim et al., "4K-memristor analog-grade passive crossbar circuit", arXiv preprint arXiv:1906.12045 (27 Jun. 2019), which is hereby incorporated by reference in its entirety.

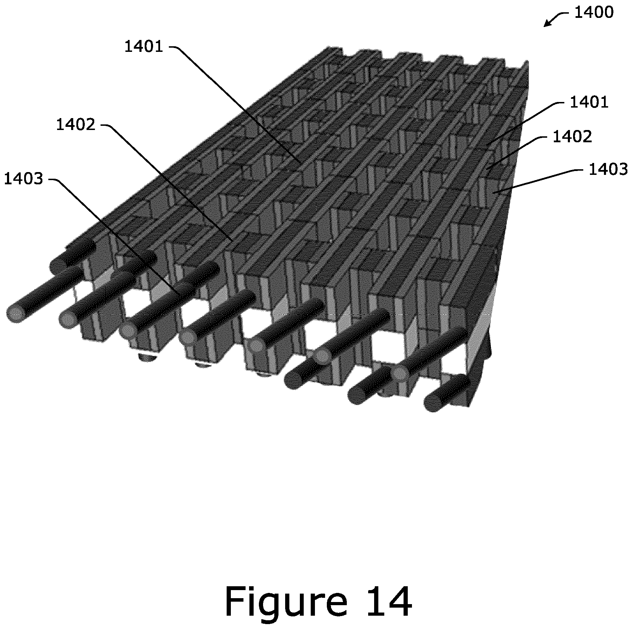

Figure 14 depicts a perspective view of an example three-dimensional (3D) synaptic structure 1400 according to various embodiments. Similar to the previously discussed embodiments, the synaptic structure 1400 includes an FTJ device 1402 located at each word and bit line cross section. In this embodiment, the synaptic structure 1400 includes BLs 1403 that are oriented vertically with respect to the WLs 1401, and/or the WLs 1401 are oriented horizontally with respect to the BLs 1403. Additionally, each vertically oriented BL 1403 is sandwiched between two FTJ/FE layers 1402. Additionally, the FTJs/FE layers 1402 are also oriented vertically. In various embodiments, the synaptic structure 1400 can achieve density of synapses comparable to those in an organic brain (e.g., >1e13).

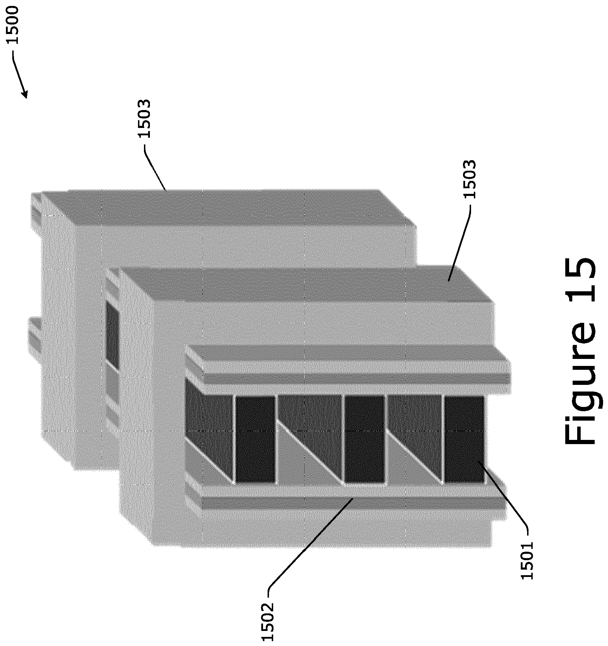

Figure 15 depicts a perspective view of another the 3D synaptic structure 1500 according to various embodiments. Similar to the synaptic structure 1400, the synaptic structure 1500 includes BLs 1503 that are oriented vertically with respect to the WLs 1501 where an FE layer 1502 is disposed between the WLs 1501 and the BLs 1503. In this embodiment, the FE layer 1502 is a continuous layer that extends in both horizontal/longitudinal and vertical/lateral directions.

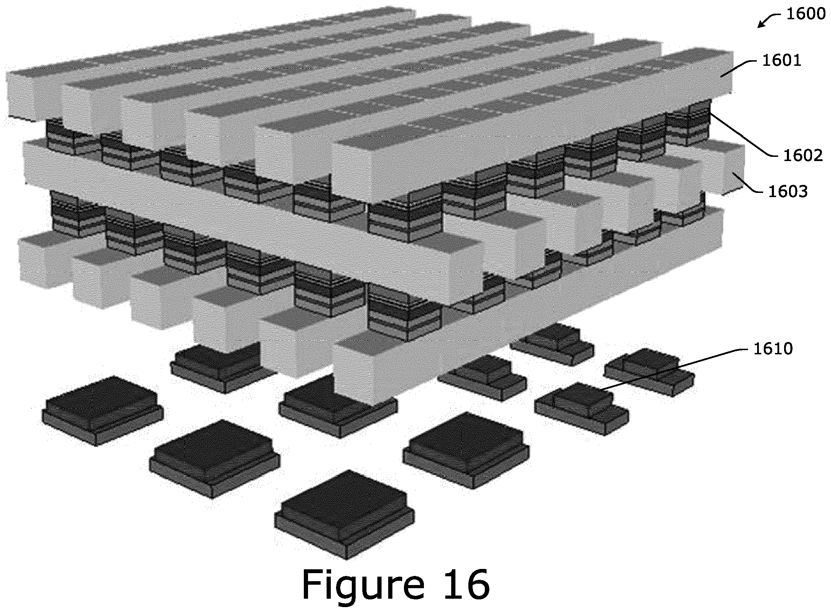

Figure 16 depicts a perspective view of another example 3D synaptic structure 1600 according to various embodiments. In this embodiment, the synaptic structure 1600 includes BLs 1603 that are oriented perpendicular to the WLs 1601. Additionally, each BL 1603 is sandwiched between two FTJ/FE layers 1602. Additionally, the FTJs/FE layers 1602 are oriented vertically with respect to the WLs 1601 and the BLs 1603. Figure 16 also shows a partially exploded view of the synaptic structure 1600 including electrodes 1610, which may be coupled to the synaptic structure 1600 (e.g., coupled to the WLs 1601 in this example).

In various embodiments, different sections of the synaptic structures 1400, 1500, 1600 can be operated separately from one another by switching the polarization of the different sections. For example, a zero voltage can be applied to the vertical BLs 1403 of synaptic structure 1400 a non-zero voltage (e.g., 2 V) may be applied to the horizontal WLs 1401, and the polarization may be switched by applying the zero voltage to the horizontal WLs 1401 and the non-zero voltage may be applied to the vertical BLs 1403.

Furthermore, in some embodiments, the WLs and/or BLs may be shaped differently than shown by Figures 1, 3-5, and 14-16. For example, in some embodiments the WLs 1401, 1501, 1601 and/or the BLs 1403, 1503, 1603 may be formed to have a cylindrical shape. In these embodiments, the cylindrical WLs 1401, 1501, 1601 and/or BLs 1403, 1503, 1603 may be wires.

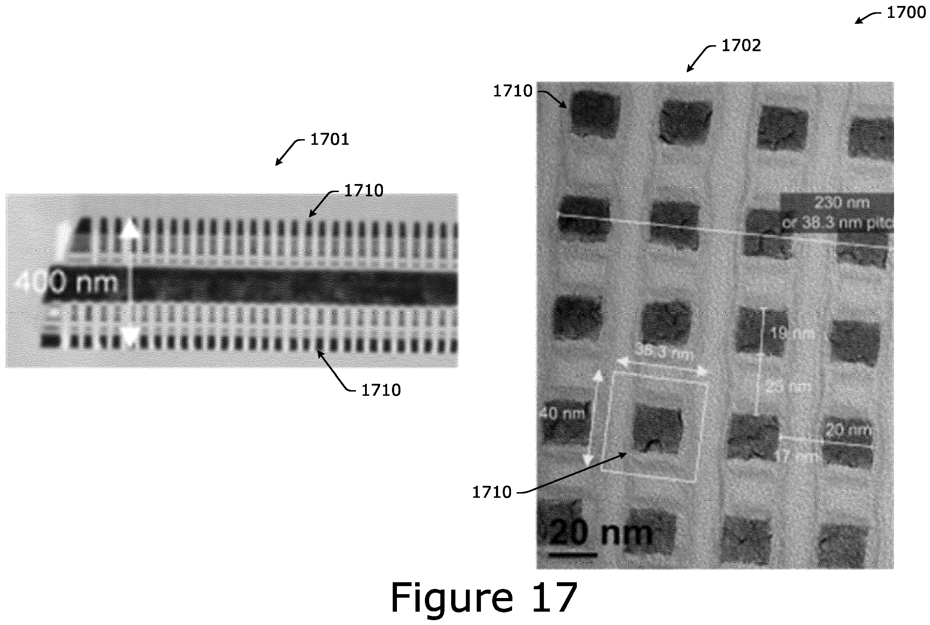

Figure 17 shows an example arrayed synaptic structure 1700 according to various embodiments. Figure 17 includes a cross section view 1701 through the arrayed synaptic structure 1700, and top view 1702 shows of the arrayed synaptic structure 1700 cut through a ferroelectric stack in between crossing metal interconnect (IX) lines. The arrayed synaptic structure 1700 includes a plurality of synapses 1710, each of which is configured to have a variable resistance as discussed previously. The plurality of synapses 1710 are geometrically arranged in a 3D grid, lattice, mesh, crossbar, and/or x-point shape. In cross section view 1701 the synapses 1710 are shown as vertical shaped elements whereas the synapses 1710 are shown as square-shaped elements in top view 1702 due to the different viewpoints from which these images were captured (note that not all synapses 1710 are labeled in Figure 17).

In embodiments, the synaptic structure 1700 includes cross a point device with a ferroelectric layer. In this example, the views 1701 and 1702 were captured using transmission electron microscopy (TEM), although scanning electron microscopy (SEM) can also be used to identify either lateral or vertical cross point devices in between crossing metal lines. TEM and/or SEM can be used to capture the interconnect stack at the metal-zero (M0) to metal-three (M3) layers, or higher, can identify the arrayed synaptic structure 1700. Furthermore, x-point and/or x-bar architectures can also be specified in product literature and/or device specifications/standards.

## 2. EXAMPLE HARDWARE AND SOFTWARE CONFIGURATIONS AND ARRANGEMENTS

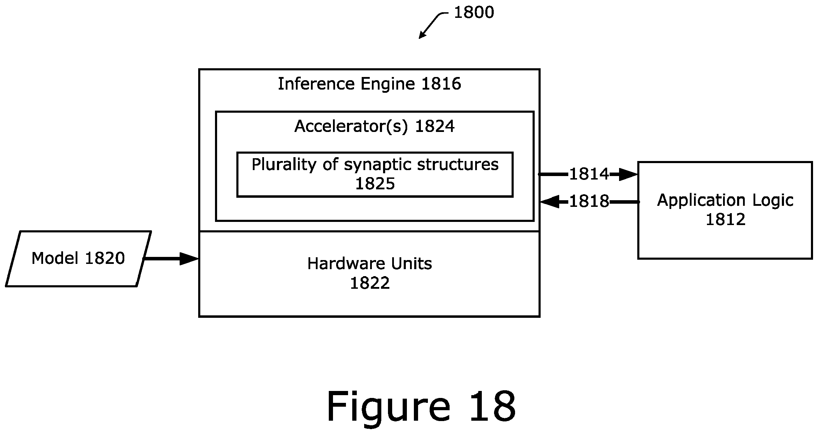

Figure 18 is an example accelerator architecture 1800 for according to various embodiments. The accelerator architecture 1800 provides ANN (e.g., DNN) functionality to one or more application logic(s) 1812, and as such, may be referred to as a neural network (NN) accelerator architecture 1800, DNN accelerator architecture 1800, and/or the like. The application logic 1812 may include application software and/or hardware components used to perform specification functions. The application logic 1812 forwards data 1814 to an inference engine 1816. The inference engine 1816 is a runtime element that delivers a unified application programming interface (API) that integrates a ANN (e.g., DNN or the like) inference with the application logic 1812 to provide a result 1818 (or output) to the application logic 1812.

To provide the inference, the inference engine 1816 uses a model 1820 that controls how the DNN inference is made on the data 1814 to generate the result 1818. Specifically, the model 1820 includes a topology of layers of the DNN. The topology includes an input layer that receives the data 1814, an output layer that outputs the result 1818, and one or more hidden layers between the input and output layers that provide processing between the data 14 and the result 1818. The topology may be stored in a suitable information object, such as an extensible markup language (XML), JavaScript Object Notation (JSON), and/or other suitable file and/or the like. The model 1820 may also include weights and/or biases for results for any of the layers while processing the data 1814 in the inference using the DNN

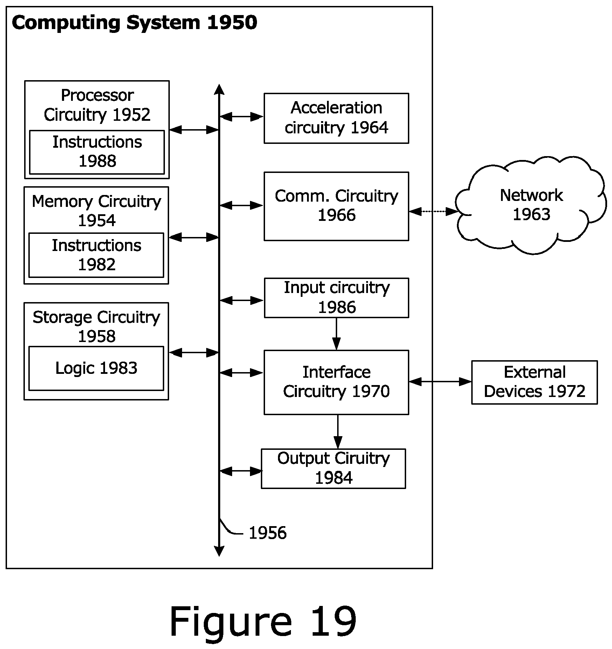

The inference engine 1816 may be implemented using and/or connected to hardware unit(s) 1822. The hardware unit(s) 1822 may include one or more processors and/or one or more programmable devices. As examples, the processors may include central processing units (CPUs), graphics processing units (GPUs), vision processing units (VPUs), tensor processing units (TPUs), Neural Compute Engine (NCE), and the like. The programmable devices may include, for example, logic arrays, programmable logic devices (PLDs) such as complex PLDs (CPLDs), field-programmable gate arrays (FPGAs), programmable Application Specific Integrated Circuits (ASICs), programmable System-on-Chip (SoC), and the like. Furthermore, the inference engine 1816 may include one or more accelerators 1824 that provide hardware acceleration for the DNN inference using one or more hardware units 1822. The one or more accelerators 1824 may include a processing element (PE) array and/or multiply-and-accumulate (MAC) architecture according to the various embodiments discussed herein. In particular, the one or more accelerators 1824 may include a plurality of synaptic structures 1825, which may be configured or arranged according to the various embodiments shown and described with respect to Figures 1-17. The processor(s) and/or programmable devices may correspond to processor circuitry 1952 of Figure 19 and the accelerator(s) 1824 may correspond to the acceleration circuitry 1964 of Figure 19 described infra.

Figure 19 illustrates an example of components that may be present in a computing system 1950 for implementing the techniques (e.g., operations, processes, methods, and methodologies) described herein. The computing system 1950 provides a closer view of the respective components of node 1900 when implemented as or as part of a computing device (e.g., as a mobile device, a base station, server, gateway, etc.). The computing system 1950 may include any combinations of the hardware or logical components referenced herein, and it may include or couple with any device usable with an edge communication network or a combination of such networks. The components may be implemented as ICs, portions thereof, discrete electronic devices, or other modules, instruction sets, programmable logic or algorithms, hardware, hardware accelerators, software, firmware, or a combination thereof adapted in the computing system 1950, or as components otherwise incorporated within a chassis of a larger system. For one embodiment, at least one processor 1952 may be packaged together with computational logic 1982 and configured to practice aspects of various example embodiments described herein to form a System in Package (SiP) or a System on Chip (SoC).

The system 1950 includes processor circuitry in the form of one or more processors 1952. The processor circuitry 1952 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1952 may include one or more hardware accelerators (e.g., same or similar to acceleration circuitry 1964), which may be microprocessors, programmable processing devices (e.g., FPGA, ASIC, etc.), or the like. The one or more accelerators may include, for example, computer vision and/or deep learning accelerators.

In some implementations, the processor circuitry 1952 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1952 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low voltage processor, an embedded processor, or any other known processing elements, or any suitable combination thereof. The processors (or cores) 1952 may be coupled with or may include memory/storage and may be configured to execute instructions stored in the memory/storage to enable various applications or operating systems to run on the platform 1950. The processors (or cores) 1952 is configured to operate application software to provide a specific service to a user of the platform 1950. In some embodiments, the processor(s) 1952 may be a special-purpose processor(s)/controller(s) configured (or configurable) to operate according to the various embodiments herein.

As examples, the processor(s) 1952 may include an Intel® Architecture Core™ based processor such as an i3, an i5, an i7, an i9 based processor; an Intel® microcontroller-based processor such as a Quark™, an Atom™, or other MCU-based processor; Pentium® processor(s), Xeon® processor(s), or another such processor available from Intel® Corporation, Santa Clara, California. However, any number other processors may be used, such as one or more of Advanced Micro Devices (AMD) Zen® Architecture such as Ryzen® or EPYC® processor(s), Accelerated Processing Units (APUs), MxGPUs, Epyc® processor(s), or the like; A5-A12 and/or S1-S4 processor(s) from Apple® Inc., Snapdragon™ or Centriq™ processor(s) from Qualcomm® Technologies, Inc., Texas Instruments, Inc.® Open Multimedia Applications Platform (OMAP)™ processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2® provided by Cavium™, Inc.; or the like. In some implementations, the processor(s) 1952 may be a part of a system on a chip (SoC), System-in-Package (SiP), a multi-chip package (MCP), and/or the like, in which the processor(s) 1952 and other components are formed into a single integrated circuit, or a single package, such as the Edison™ or Galileo™ SoC boards from Intel® Corporation. Other examples of the processor(s) 1952 are mentioned elsewhere in the present disclosure.

The system 1950 may include or be coupled to acceleration circuitry 1964, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1964 may comprise logic blocks or logic fabric and other interconnected resources that may be programmed (configured) to perform various functions, such as the procedures, methods, functions, etc. of the various embodiments discussed herein. In such implementations, the acceleration circuitry 1964 may also include memory cells (e.g., EPROM, EEPROM, flash memory, static memory (e.g., SRAM, antifuses, etc.) used to store logic blocks, logic fabric, data, etc. in LUTs and the like.

In some implementations, the processor circuitry 1952 and/or acceleration circuitry 1964 may include hardware elements specifically tailored for machine learning functionality, such as for operating performing ANN operations such as those discussed herein. In these implementations, the processor circuitry 1952 and/or acceleration circuitry 1964 may be, or may include, an AI engine chip that can run many different kinds of AI instruction sets once loaded with the appropriate weightings and training code. Additionally or alternatively, the processor circuitry 1952 and/or acceleration circuitry 1964 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google® Inc., Real AI Processors (RAPs™) provided by AlphaICs®, Nervana™ Neural Network Processors (NNPs) provided by Intel® Corp., Intel® Movidius™ Myriad™ X Vision Processing Unit (VPU), NVIDIA® PX™ based GPUs, the NM500 chip provided by General Vision®, Hardware 3 provided by Tesla®, Inc., an Epiphany™ based processor provided by Adapteva®, or the like. In some embodiments, the processor circuitry 1952 and/or acceleration circuitry 1964 and/or hardware accelerator circuitry may be implemented as AI accelerating co-processor(s), such as the Hexagon 685 DSP provided by Qualcomm®, the PowerVR 2NX Neural Net Accelerator (NNA) provided by Imagination Technologies Limited®, the Neural Engine core within the Apple® A11 or A12 Bionic SoC, the Neural Processing Unit (NPU) within the HiSilicon Kirin 970 provided by Huawei®, and/or the like. In some hardware-based implementations, individual subsystems of system 1950 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1950 also includes system memory 1954. Any number of memory devices may be used to provide for a given amount of system memory. As examples, the memory 1954 may be, or include, volatile memory such as random access memory (RAM), static RAM (SRAM), dynamic RAM (DRAM), synchronous DRAM (SDRAM), RAMBUS® Dynamic Random Access Memory (RDRAM®), and/or any other desired type of volatile memory device. Additionally or alternatively, the memory 1954 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1954 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1958 provides persistent storage of information such as data, applications, operating systems and so forth. In an example, the storage 1958 may be implemented via a solid-state disk drive (SSDD) and/or high-speed electrically erasable memory (commonly referred to as "flash memory"). Other devices that may be used for the storage 1958 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1954 and/or storage circuitry 1958 may also incorporate three-dimensional (3D) cross-point (XPOINT) memories from Intel® and Micron®.

The memory circuitry 1954 and/or storage circuitry 1958 is/are configured to store computational logic 1983 in the form of software, firmware, microcode, or hardware-level instructions to implement the techniques described herein. The computational logic 1983 may be employed to store working copies and/or permanent copies of programming instructions, or data to create the programming instructions, for the operation of various components of system 1900 (e.g., drivers, libraries, application programming interfaces (APIs), etc.), an operating system of system 1900, one or more applications, and/or for carrying out the embodiments discussed herein. The computational logic 1983 may be stored or loaded into memory circuitry 1954 as instructions 1982, or data to create the instructions 1982, which are then accessed for execution by the processor circuitry 1952 to carry out the functions described herein. The processor circuitry 1952 and/or the acceleration circuitry 1964 accesses the memory circuitry 1954 and/or the storage circuitry 1958 over the IX 1956. The instructions 1982 direct the processor circuitry 1952 to perform a specific sequence or flow of actions, for example, as described with respect to flowchart(s) and block diagram(s) of operations and functionality depicted previously. The various elements may be implemented by assembler instructions supported by processor circuitry 1952 or high-level languages that may be compiled into instructions 1981, or data to create the instructions 1981, to be executed by the processor circuitry 1952. The permanent copy of the programming instructions may be placed into persistent storage devices of storage circuitry 1958 in the factory or in the field through, for example, a distribution medium (not shown), through a communication interface (e.g., from a distribution server (not shown)), over-the-air (OTA), or any combination thereof.

The IX 1956 couples the processor 1952 to communication circuitry 1966 for communications with other devices, such as a remote server (not shown) and the like. The communication circuitry 1966 is a hardware element, or collection of hardware elements, used to communicate over one or more networks 1963 and/or with other devices. In one example, communication circuitry 1966 is, or includes, transceiver circuitry configured to enable wireless communications using any number of frequencies and protocols such as, for example, the Institute of Electrical and Electronics Engineers (IEEE) 802.11 (and/or variants thereof), IEEE 802.15.4, Bluetooth® and/or Bluetooth® low energy (BLE), ZigBee®, LoRaWAN™ (Long Range Wide Area Network), a cellular protocol such as 3GPP LTE and/or Fifth Generation (5G)/New Radio (NR), and/or the like. Additionally or alternatively, communication circuitry 1966 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others. In some embodiments, the communication circuitry 1966 may include or otherwise be coupled with the an accelerator 1824 including one or more synaptic devices/structures 100, 900, 1400, 1500, 1600, 1700, etc., as described previously, in accordance with various embodiments.

The IX 1956 also couples the processor 1952 to interface circuitry 1970 that is used to connect system 1950 with one or more external devices 1972. The external devices 1972 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1950, which are referred to as input circuitry 1986 and output circuitry 1984 in Figure 19. The input circuitry 1986 and output circuitry 1984 include one or more user interfaces designed to enable user interaction with the platform 1950 and/or peripheral component interfaces designed to enable peripheral component interaction with the platform 1950. Input circuitry 1986 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1984 may be included to show information or otherwise convey information, such as sensor readings, actuator position(s), or other like information. Data and/or graphics may be displayed on one or more user interface components of the output circuitry 1984. Output circuitry 1984 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Chrystal Displays (LCD), LED displays, quantum dot displays, projectors, etc.), with the output of characters, graphics, multimedia objects, and the like being generated or produced from the operation of the platform 1950. The output circuitry 1984 may also include speakers and/or other audio emitting devices, printer(s), and/or the like. Additionally or alternatively, sensor(s) may be used as the input circuitry 1984 (e.g., an image capture device, motion capture device, or the like) and one or more actuators may be used as the output device circuitry 1984 (e.g., an actuator to provide haptic feedback or the like). Peripheral component interfaces may include, but are not limited to, a non-volatile memory port, a USB port, an audio jack, a power supply interface, etc. A display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1950 may communicate over the interconnect (IX) 1956. The IX 1956 may include any number of technologies, including ISA, extended ISA, I2C, SPI, point-to-point interfaces, power management bus (PMBus), PCI, PCIe, PCIx, Intel® UPI, Intel® Accelerator Link, Intel® CXL, CAPI, OpenCAPI, Intel® QPI, UPI, Intel® OPA IX, RapidIO™ system IXs, CCIX, Gen-Z Consortium IXs, a HyperTransport interconnect, NVLink provided by NVIDIA®, a Time-Trigger Protocol (TTP) system, a FlexRay system, PROFIBUS, and/or any number of other IX technologies. The IX 1956 may be a proprietary bus, for example, used in a SoC based system.

The number, capability, and/or capacity of the elements of system 1900 may vary, depending on whether computing system 1900 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1900 may comprise one or more components of a data center, a desktop computer, a workstation, a laptop, a smartphone, a tablet, a digital camera, a smart appliance, a smart home hub, a network appliance, and/or any other device/system that processes data.


## 3. EXAMPLE IMPLEMENTATIONS

Additional examples of the presently described embodiments include the following, non-limiting example implementations. Each of the following non-limiting examples may stand on its own or may be combined in any permutation or combination with any one or more of the other examples provided below or throughout the present disclosure.

Example 1 includes a synaptic structure to be employed in an artificial neural network (ANN) integrated circuit (IC), the synaptic structure comprising: a plurality of bitlines (BLs); a plurality of wordlines (WLs) intersecting the plurality of BLs; and a plurality of ferroelectric tunnel junctions (FTJs), each FTJ of the plurality of FTJs disposed at respective intersection points between individual BLs of the plurality of BLs and individual WLs of the plurality of WLs.

Example 2 includes the synaptic structure of claim 1 and/or some other example(s) herein, further comprising: a plurality of synapses of the ANN, wherein each synapse of the plurality of synapses is formed by an intersection point of the respective intersection points.

Example 3 includes the synaptic structure of claims 1-2 and/or some other example(s) herein, wherein the plurality of WLs and the plurality of BLs are arranged in a three-dimensional (3D) grid.

Example 4 includes the synaptic structure of claims 1-3 and/or some other example(s) herein, wherein the individual BLs are laterally separated from other BLs of the plurality of BLs, the individual WLs are laterally separated from other WLs of the plurality of WLs, and the individual BLs are longitudinally separated from the individual WLs.

Example 5 includes the synaptic structure of claim 4 and/or some other example(s) herein, wherein the plurality of FTJs longitudinally separate the individual BLs from the individual WLs.

Example 6 includes the synaptic structure of claims 1-5 and/or some other example(s) herein, wherein the plurality of BLs are perpendicular to the plurality of WLs in a lateral plane.

Example 7 includes the synaptic structure of claims 1-6 and/or some other example(s) herein, wherein the plurality of BLs are perpendicular to the plurality of WLs in a longitudinal plane.

Example 8 includes the synaptic structure of claims 1-7 and/or some other example(s) herein, wherein the synaptic structure is configured to perform one or more ANN operations based on an input voltage applied to the plurality of BLs or the input voltage applied to the plurality of WLs.

Example 9 includes the synaptic structure of claim 8 and/or some other example(s) herein, wherein, when the input voltage is applied to the individual WLs, current flows through corresponding FTJs of the plurality of FTJs and is accumulated on the individual BLs.

Example 10 includes the synaptic structure of claims 1-9 and/or some other example(s) herein, wherein the plurality of BLs comprise copper (Cu), tungsten (W), Ruthenium (Ru), Cobalt (Co), tungsten nitride (WN), titanium nitride (TiN), or a combination thereof, and the plurality of WLs comprise Cu, W, Ru, Co, WN, TiN, or a combination thereof.

Example 11 includes the synaptic structure of claims 1-10 and/or some other example(s) herein, wherein the plurality of FTJs comprise, hafnium oxide ($HfO_2$), hafnium-zirconia ($HfZrO_2$), hafnium zirconium oxide ($Hf_xZr_{1-x}O_2$ ($0.3 \leq x \leq 0.5$)), lead zirconate titanate ($Pb[Zr_xTi_{1-x}]O_3$ ($0 \leq x \leq 1$), barium titanate ($BaTiO_3$), bismuth ferrite ($BiFeO_3$), $Al_xSc_{1-x}N$ ($0.6 \leq x \leq 0.9$), $Al_xSc_{1-x}O_2$($0.6 \leq x \leq 0.9$), or combinations thereof.

Example 12 includes a method of fabricating a synaptic structure to be employed in an artificial neural network (ANN), the method comprising: depositing a ferroelectric (FE) material on a wordline (WL) material; forming a WL structure including patterning the WL material with the deposited FE material; depositing a bitline (BL) material on the FE material; and forming a BL structure including patterning the BL material in an opposite direction as the WL structure.

Example 13 includes the method of claim 12 and/or some other example(s) herein, wherein the forming the WL structure comprises performing lithography and an etching process to form the WL material with the WL material with the deposited FE material.

Example 14 includes the method of claims 12-13 and/or some other example(s) herein, wherein the forming the BL structure comprises performing lithography on the BL material and performing an etching process on the BL material and the FE material.

Example 15 includes the method of claims 12-14 and/or some other example(s) herein, wherein depositing the FE material comprises: depositing a bottom electrode material on the WL material; depositing an active oxide material on the bottom electrode material; and depositing a top electrode material on the active oxide material.

Example 16 includes the method of claims 12-15 and/or some other example(s) herein, further comprising: encapsulating the WL structure with a nitride material after forming the WL structure; and encapsulating the BL structure with the nitride material or another nitride material after forming the BL structure

Example 17 includes a system, comprising: an artificial neural network (ANN) integrated circuit (IC), comprising a plurality of synapses, wherein each synapse of the plurality of synapses is formed by ferroelectric tunnel junction (FTJ) coupling a portion of a bitline (BL) of a plurality of BLs and a portion of a wordline (WL) of a plurality of WLs, and each synapse is configured to perform an ANN operation based on an input voltage applied to the plurality of WLs and output a current on a corresponding BL of the plurality of BLs; and a processor communicatively coupled to the ANN IC to provide data for modulation into the input voltage.

Example 18 includes the system of claim 17 and/or some other example(s) herein, wherein the plurality of WLs and the plurality of BLs are arranged in a three-dimensional (3D) grid such that individual BLs are laterally separated from other BLs of the plurality of BLs, individual WLs are laterally separated from other WLs of the plurality of WLs, and the individual BLs are longitudinally separated from the individual WLs.

Example 19 includes the system of claims 17-18 and/or some other example(s) herein, wherein the plurality of BLs are arranged perpendicular to the plurality of WLs in a lateral or longitudinal plane.

Example 20 includes the system of claims 17-19 and/or some other example(s) herein, wherein the input voltage being applied to the individual WLs, is to cause current to flow through the FTJ of individual synapses of the plurality of synapses and is accumulated on corresponding BLs of the individual synapses.

Example 21 includes the system of claims 17-20 and/or some other example(s) herein, wherein the system is a central processing unit (CPU), graphics processing unit (GPU), vision processing unit (VPU), tensor processing unit (TPU), Neural Compute Engine (NCE), Neural Network Processor (NNP), a Vision Processing Unit (VPU), or a hardware accelerator.

Example Z01 includes one or more computer readable media comprising instructions, wherein execution of the instructions by processor circuitry is to cause the processor circuitry to perform the method of any one of examples 1-21 and/or some other example(s) herein.

Example Z02 includes a computer program comprising the instructions of example Z01.

Example Z03a includes an Application Programming Interface defining functions, methods, variables, data structures, and/or protocols for the computer program of example Z02.

Example Z03b includes an API or specification defining functions, methods, variables, data structures, protocols, etc., defining or involving use of any of examples 1-21 or portions thereof, or otherwise related to any of examples 1-21 or portions thereof.

Example Z04 includes an apparatus comprising circuitry loaded with the instructions of example Z01.

Example Z05 includes an apparatus comprising circuitry operable to run the instructions of example Z01.

Example Z06 includes an integrated circuit comprising one or more of the processor circuitry of example Z01 and the one or more computer readable media of example Z01.

Example Z07 includes a computing system comprising the one or more computer readable media and the processor circuitry of example Z01.

Example Z08 includes an apparatus comprising means for executing the instructions of example Z01.

Example Z09 includes a signal generated as a result of executing the instructions of example Z01.

Example Z10 includes a data unit generated as a result of executing the instructions of example Z01.

Example Z11 includes the data unit of example Z10 and/or some other example(s) herein, wherein the data unit is a datagram, network packet, data frame, data segment, a Protocol Data Unit (PDU), a Service Data Unit (SDU), a message, or a database object.

Example Z12 includes a signal encoded with the data unit of examples Z10 and/or Z11.

Example Z13 includes an electromagnetic signal carrying the instructions of example Z01.

Example Z14 includes any of examples Z01-Z13 and/or one or more other example(s) herein, wherein the computing system and/or the processor circuitry comprises one or more of a System-in-Package (SiP), Multi-Chip Package (MCP), a System-on-Chips (SoC), a digital signal processors (DSP), a field-programmable gate arrays (FPGA), an Application Specific Integrated Circuits (ASIC), a programmable logic devices (PLD), a Central Processing Unit (CPU), a Graphics Processing Unit (GPU), or the computing system and/or the processor circuitry comprises two or more of SiPs, MCPs, SoCs, DSPs, FPGAs, ASICs, PLDs, CPUs, GPUs interconnected with one another.

Example Z15 includes an apparatus comprising means for performing the method of any one of examples 1-21 and/or some other example(s) herein.

Any of the above-described examples may be combined with any other example (or combination of examples), unless explicitly stated otherwise. Implementation of the preceding techniques may be accomplished through any number of specifications, configurations, or example deployments of hardware and software. It should be understood that the functional units or capabilities described in this specification may have been referred to or labeled as components or modules, in order to more particularly emphasize their implementation independence. Such components may be embodied by any number of software or hardware forms. For example, a component or module may be implemented as a hardware circuit comprising custom very-large-scale integration (VLSI) circuits or gate arrays, off-the-shelf semiconductors such as logic chips, transistors, or other discrete components. A component or module may also be implemented in programmable hardware devices such as field programmable gate arrays, programmable array logic, programmable logic devices, or the like. Components or modules may also be implemented in software for execution by various types of processors. An identified component or module of executable code may, for instance, comprise one or more physical or logical blocks of computer instructions, which may, for instance, be organized as an object, procedure, or function. Nevertheless, the executables of an identified component or module need not be physically located together, but may comprise disparate instructions stored in different locations which, when joined logically together, comprise the component or module and achieve the stated purpose for the component or module.

Indeed, a component or module of executable code may be a single instruction, or many instructions, and may even be distributed over several different code segments, among different programs, and across several memory devices or processing systems. In particular, some aspects of the described process (such as code rewriting and code analysis) may take place on a different processing system (e.g., in a computer in a data center), than that in which the code is deployed (e.g., in a computer embedded in a sensor or robot). Similarly, operational data may be identified and illustrated herein within components or modules, and may be embodied in any suitable form and organized within any suitable type of data structure. The operational data may be collected as a single data set, or may be distributed over different locations including over different storage devices, and may exist, at least partially, merely as electronic signals on a system or network. The components or modules may be passive or active, including agents operable to perform desired functions

## 4. TERMINOLOGY

In the preceding detailed description, reference is made to the accompanying drawings which form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous. Where the disclosure recites "a" or "a first" element or the equivalent thereof, such disclosure includes one or more such elements, neither requiring nor excluding two or more such elements. Further, ordinal indicators (e.g., first, second or third) for identified elements are used to distinguish between the elements, and do not indicate or imply a required or limited number of such elements, nor do they indicate a particular position or order of such elements unless otherwise specifically stated.

As used herein, the singular forms "a," "an" and "the" are intended to include plural forms as well, unless the context clearly indicates otherwise. It will be further understood that the terms "comprises" and/or "comprising," when used in this specification, specific the presence of stated features, integers, steps, operations, elements, and/or components, but do not preclude the presence or addition of one or more other features, integers, steps, operation, elements, components, and/or groups thereof. The phrase "A and/or B" means (A), (B), or (A and B). For the purposes of the present disclosure, the phrase "A, B, and/or C" means (A), (B), (C), (A and B), (A and C), (B and C), or (A, B and C). The description may use the phrases "in an embodiment," or "In some embodiments," which may each refer to one or more of the same or different embodiments. Furthermore, the terms "comprising," "including," "having," and the like, as used with respect to embodiments of the present disclosure, are synonymous.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or ink, and/or the like.

The term "fabrication" refers to the formation, construction, or creation of a structure using any combination of materials and/or using fabrication means. The term "fabrication means" as used herein refers to any suitable tool or machine that is used during a fabrication process and may involve tools or machines for cutting (e.g., using manual or powered saws, shears, chisels, routers, torches including handheld torches such as oxy-fuel torches or plasma torches, and/or computer numerical control (CNC) cutters including lasers, mill bits, torches, water jets, routers, laser etching tools/machines, tolls/machines for printed circuit board (PCB) and/or semiconductor manufacturing, etc.), bending (e.g., manual, powered, or CNC hammers, pan brakes, press brakes, tube benders, roll benders, specialized machine presses, etc.), forging (e.g., forging press, machines/tools for roll forging, swaging, cogging, open-die forging, impression-die forging (close die forging), press forging, cold forging automatic hot forging and upsetting, etc.), assembling (e.g., by welding, soldering, brazing, crimping, coupling with adhesives, riveting, fasteners, etc.), molding or casting (e.g., die casting, centrifugal casting, injection molding, extrusion molding, matrix molding, etc.), additive manufacturing (e.g., direct metal laser sintering, filament winding, fused deposition modeling, laminated object manufacturing techniques, induction printing, selecting laser sintering, spark plasma sintering, stereolithographic, three-dimensional (3D) printing techniques including fused deposition modeling, selective laser melting, selective laser sintering, composite filament fabrication, fused filament fabrication, stereo lithography, directed energy deposition, electron beam freeform fabrication, etc.), PCB and/or semiconductor manufacturing techniques (e.g., silk-screen printing, photolithography, photoengraving, PCB milling, laser resist ablation, laser etching, plasma exposure, atomic layer deposition (ALD), molecular layer deposition (MLD), chemical vapor deposition (CVD), rapid thermal processing (RTP), and/or the like).

The terms "flexible," "flexibility," and/or "pliability" refer to the ability of an object or material to bend or deform in response to an applied force; "the term "flexible" is complementary to "stiffness." The term "stiffness" and/or "rigidity" refers to the ability of an object to resist deformation in response to an applied force. The term "elasticity" refers to the ability of an object or material to resist a distorting influence or stress and to return to its original size and shape when the stress is removed. Elastic modulus (a measure of elasticity) is a property of a material, whereas flexibility or stiffness is a property of a structure or component of a structure and is dependent upon various physical dimensions that describe that structure or component.

The term "wear" refers to the phenomenon of the gradual removal, damaging, and/or displacement of material at solid surfaces due to mechanical processes (e.g., erosion) and/or chemical processes (e.g., corrosion). Wear causes functional surfaces to degrade, eventually leading to material failure or loss of functionality. The term "wear" as used herein may also include other processes such as fatigue (e.g., he weakening of a material caused by cyclic loading that results in progressive and localized structural damage and the growth of cracks) and creep (e.g., the tendency of a solid material to move slowly or deform permanently under the influence of persistent mechanical stresses). Mechanical wear may occur as a result of relative motion occurring between two contact surfaces. Wear that occurs in machinery components has the potential to cause degradation of the functional surface and ultimately loss of functionality. Various factors, such as the type of loading, type of motion, temperature, lubrication, and the like may affect the rate of wear.

The term "lateral" refers to directions or positions relative to an object spanning the width of a body of the object, relating to the sides of the object, and/or moving in a sideways direction with respect to the object. The term "longitudinal" refers to directions or positions relative to an object spanning the length of a body of the object; relating to the top or bottom of the object, and/or moving in an upwards and/or downwards direction with respect to the object. The term "linear" refers to directions or positions relative to an object following a straight line with respect to the object, and/or refers to a movement or force that occurs in a straight line rather than in a curve. The term "lineal" refers to directions or positions relative to an object following along a given path with respect to the object, wherein the shape of the path is straight or not straight.

The term "vertex" refers to a corner point of a polygon, polyhedron, or other higher-dimensional polytope, formed by the intersection of edges, faces or facets of the object. A vertex is "convex" if the internal angle of the polygon (i.e., the angle formed by the two edges at the vertex with the polygon inside the angle) is less than $\pi$ radians (180°); otherwise, it is a "concave" or "reflex" polygon. The term "slope" refers to the steepness or the degree of incline of a surface. The term "aspect" refers to an orientation of a slope, which may be measured clockwise in degrees from 0 to 360, where 0 is north-facing, 90 is east-facing, 180 is south-facing, and 270 is west-facing.

The term "circuitry" refers to a circuit or system of multiple circuits configurable to perform a particular function in an electronic device. The circuit or system of circuits may be part of, or include one or more hardware components, such as a logic circuit, a processor (shared, dedicated, or group) and/or memory (shared, dedicated, or group), an Application Specific Integrated Circuit (ASIC), a field-programmable gate array (FPGA), programmable logic device (PLD), System-on-Chip (SoC), System-in-Package (SiP), Multi-Chip Package (MCP), digital signal processor (DSP), etc., that are configurable to provide the described functionality. In addition, the term "circuitry" may also refer to a combination of one or more hardware elements with the program code used to carry out the functionality of that program code. Some types of circuitry may execute one or more software or firmware programs to provide at least some of the described functionality. Such a combination of hardware elements and program code may be referred to as a particular type of circuitry.

The term "architecture" as used herein refers to a computer architecture or a network architecture. A "computer architecture" is a physical and logical design or arrangement of software and/or hardware elements in a computing system or platform including technology standards for interacts therebetween.

As used herein, the term "optical waveguide" can refer to any physical device or structure that guides light (e.g., an optical signal) in a confined manner. In embodiments, the optical waveguides include silicon-based optical waveguides having a core for confinement of light and formation of modes surrounded by a cladding or substrate, having a lower refractive index than the core.

The term "machine learning" or "ML" refers to the use of computer systems to optimize a performance criterion using example (training) data and/or past experience. ML involves using algorithms to perform specific task(s) without using explicit instructions to perform the specific task(s), but instead relying on learnt patterns and/or inferences. ML uses statistics to build mathematical model(s) (also referred to as "ML models" or simply "models") in order to make predictions or decisions based on sample data (e.g., training data). The model is defined to have a set of parameters, and learning is the execution of a computer program to optimize the parameters of the model using the training data or past experience. The trained model may be a predictive model that makes predictions based on an input dataset, a descriptive model that gains knowledge from an input dataset, or both predictive and descriptive. Once the model is learned (trained), it can be used to make inferences (e.g., predictions). ML algorithms perform a training process on a training dataset to estimate an underlying ML model. An ML algorithm is a computer program that learns from experience with respect to some task(s) and some performance measure(s)/metric(s), and an ML model is an object or data structure created after an ML algorithm is trained with training data. In other words, the term "ML model" or "model" may describe the output of an ML algorithm that is trained with training data. After training, an ML model may be used to make predictions on new datasets. Additionally, separately trained AI/ML models can be chained together in a AI/ML pipeline during inference or prediction generation. Although the term "ML algorithm" refers to different concepts than the term "ML model," these terms may be used interchangeably for the purposes of the present disclosure. ML techniques generally fall into the following main types of learning problem categories: supervised learning, unsupervised learning, and reinforcement learning.

The term "supervised learning" refers to an ML technique that aims to learn a function or generate an ML model that produces an output given a labeled data set. Supervised learning algorithms build models from a set of data that contains both the inputs and the desired outputs. For example, supervised learning involves learning a function or model that maps an input to an output based on example input-output pairs or some other form of labeled training data including a set of training examples. Each input-output pair includes an input object (e.g., a vector) and a desired output object or value (referred to as a "supervisory signal"). Supervised learning can be grouped into classification algorithms, regression algorithms, and instance-based algorithms.

The term "classification" in the context of ML may refer to an ML technique for determining the classes to which various data points belong. Here, the term "class" or "classes" may refer to categories, and are sometimes called "targets" or "labels." Classification is used when the outputs are restricted to a limited set of quantifiable properties. Classification algorithms may describe an individual (data) instance whose category is to be predicted using a feature vector. As an example, when the instance includes a collection (corpus) of text, each feature in a feature vector may be the frequency that specific words appear in the corpus of text. In ML classification, labels are assigned to instances, and models are trained to correctly predict the pre-assigned labels of from the training examples. ML algorithms for classification may be referred to as a "classifier." Examples of classifiers include linear classifiers, k-nearest neighbor (kNN), decision trees, random forests, support vector machines (SVMs), Bayesian classifiers, convolutional neural networks (CNNs), among many others (note that some of these algorithms can be used for other ML tasks as well)..

The terms "regression algorithm" and/or "regression analysis" in the context of ML may refer to a set of statistical processes for estimating the relationships between a dependent variable (often referred to as the "outcome variable") and one or more independent variables (often referred to as "predictors", "covariates", or "features"). Examples of regression algorithms/models include logistic regression, linear regression, gradient descent (GD), stochastic GD (SGD), and the like.

The terms "instance-based learning" or "memory-based learning" in the context of ML may refer to a family of learning algorithms that, instead of performing explicit generalization, compares new problem instances with instances seen in training, which have been stored in memory. Examples of instance-based algorithms include k-nearest neighbor, and the like), decision tree Algorithms (e.g., Classification And Regression Tree (CART), Iterative Dichotomiser 3 (ID3), C4.5, chi-square automatic interaction detection (CHAID), etc.), Fuzzy Decision Tree (FDT), and the like), Support Vector Machines (SVM), Bayesian Algorithms (e.g., Bayesian network (BN), a dynamic BN (DBN), Naive Bayes, and the like), and ensemble algorithms (e.g., Extreme Gradient Boosting, voting ensemble, bootstrap aggregating ("bagging"), Random Forest and the like.

The term "feature" in the context of ML refers to an individual measureable property, quantifiable property, or characteristic of a phenomenon being observed. Features are usually represented using numbers/numerals (e.g., integers), strings, variables, ordinals, real-values, categories, and/or the like. A set of features may be referred to as a "feature vector." A "vector" may refer to a tuple of one or more values called scalars, and a "feature vector" may be a vector that includes a tuple of one or more features.

The term "unsupervised learning" refers to an ML technique that aims to learn a function to describe a hidden structure from unlabeled data. Unsupervised learning algorithms build models from a set of data that contains only inputs and no desired output labels. Unsupervised learning algorithms are used to find structure in the data, like grouping or clustering of data points. Examples of unsupervised learning are K-means clustering, principal component analysis (PCA), and topic modeling, among many others. The term "semi-supervised learning" refers to ML algorithms that develop ML models from incomplete training data, where a portion of the sample input does not include labels.

The term "reinforcement learning" or "RL" refers to a goal-oriented learning technique based on interaction with an environment. In RL, an agent aims to optimize a long-term objective by interacting with the environment based on a trial and error process. Examples of RL algorithms include Markov decision process, Markov chain, Q-learning, multi-armed bandit learning, and deep RL.

The terms "artificial neural network", "neural network", or "NN" refer to an ML technique comprising a collection of connected artificial neurons or nodes that (loosely) model neurons in a biological brain that can transmit signals to other arterial neurons or nodes, where connections (or edges) between the artificial neurons or nodes are (loosely) modeled on synapses of a biological brain. The artificial neurons and edges typically have a weight that adjusts as learning proceeds. The weight increases or decreases the strength of the signal at a connection. Neurons may have a threshold such that a signal is sent only if the aggregate signal crosses that threshold. The artificial neurons can be aggregated or grouped into one or more layers where different layers may perform different transformations on their inputs. Signals travel from the first layer (the input layer), to the last layer (the output layer), possibly after traversing the layers multiple times. NNs are usually used for supervised learning, but can be used for unsupervised learning as well. Examples of NNs include deep NN (DNN), feed forward NN (FFN), a deep FNN (DFF), convolutional NN (CNN), deep CNN (DCN), deconvolutional NN (DNN), a deep belief NN, a perception NN, recurrent NN (RNN) (e.g., including Long Short Term Memory (LSTM) algorithm, gated recurrent unit (GRU), etc.), deep stacking network (DSN), and Optical NNs (ONNs).

As used herein, the terms "sparse vector", "sparse matrix", and "sparse array" refer to an input vector, matrix, or array including both non-zero elements and zero elements. As used herein, the terms "ZVC data vector" "ZVC matrix", and "ZVC array" refer to a vector, matrix, or array that includes all non-zero elements of a vector, matrix, or array in the same order as a sparse vector, matrix, or array, but excludes all zero elements. As used herein, the term "dense vector", "dense matrix", and "dense array" refer to an input vector, matrix, or array including all non-zero elements.

As used herein, the term "substrate" may refer to a supporting material upon which, or within which, the elements of a semiconductor device are fabricated or attached. Additionally or alternatively, the term "substrate of a film integrated circuit" may refer to a piece of material forming a supporting base for film circuit elements and possibly additional components. Additionally or alternatively, the term "substrate of a flip chip die" may refer to a supporting material upon which one or more semiconductor flip chip die are attached. Additionally or alternatively, the term "original substrate" may refer to an original semiconductor material being processed. The original material may be a layer of semiconductor material cut from a single crystal, a layer of semiconductor material deposited on a supporting base, or the supporting base itself. Additionally or alternatively, the term "remaining substrate" The part of the original material that remains essentially unchanged when the device elements are formed upon or within the original material.

As used herein, the term "wafer" may refer to a slice or flat disk, either of semiconductor material or of such a material deposited on a substrate, in which circuits or devices are simultaneously processed and subsequently separated into chips if there is more than one device. Additionally or alternatively, the term "wafer-level package" may refer to a package whose size is generally equal to the size of the semiconductor device it contains and that is formed by processing on a complete wafer rather than on an individual device. In some cases, because of the wafer-level processing, the size of a wafer-level package may be defined by finer dimensions and tighter tolerances than those for a similar non-wafer-level package. Furthermore, the package size may change with changes in the size of the die.

As used herein, the term *"in situ"*, in the context of semiconductor fabrication and processing, is a technique in which several processes are carried out in sequence without exposing a wafer to air between the process steps. These processes can be combinations of different deposition and/or annealing processes such as rapid thermal processing (RTP), oxidation, chemical vapor deposition (CVD), atomic layer deposition (ALD), molecular layer deposition (MLD), surface cleaning, rapid thermal oxidation, nitridation, polysilicon deposition, and the like. in-situ scanning tunneling microscopy (STM) refers to a high-resolution technique for studying the structural and electronic properties of surfaces in coordinate space with atomic resolution directly under ultra-high vacuum (UHV) conditions, preserving the fabricated structures from oxidation and contamination.

As used herein, the term "etch" or "etching" refers to a process in which a controlled quantity or thickness of material is removed (often selectively) from a surface by chemical reaction, electrolysis, or other means. As used herein, the term "plasma etching" refers to a process in which material is removed by a reaction with chemically active radicals created by an ion bombardment in a glow discharge. In some cases, a mask is usually used in order to remove only selected areas. The term "mask" may refer to a patterned screen of any of several materials and types used in shielding selected areas of a semiconductor, photosensitive layer, or substrate from radiation during processing, so that the unshielded areas can be further processed to reproduce the chosen pattern. The type of mask can be designated either by type (e.g., oxide mask or metal mask) or by function (e.g., diffusion mask or vapor-deposition mask).

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

**Claims**

1. A synaptic structure for an artificial neural network (ANN) integrated circuit (IC), the synaptic structure comprising:

   a plurality of bitlines (BLs);
   a plurality of wordlines (WLs) intersecting the plurality of BLs; and
   a plurality of ferroelectric tunnel junctions (FTJs), each FTJ of the plurality of FTJs disposed at respective intersection points between individual BLs of the plurality of BLs and individual WLs of the plurality of WLs.

2. The synaptic structure of claim 1, further comprising:
   a plurality of synapses of the ANN, wherein each synapse of the plurality of synapses is formed by an intersection point of the respective intersection points.

3. The synaptic structure of claim 1 or 2, wherein the plurality of WLs and the plurality of BLs are arranged in a three-dimensional (3D) grid.

4. The synaptic structure of claims 1-3, wherein the individual BLs are laterally separated from other BLs of the plurality of BLs, the individual WLs are laterally separated from other WLs of the plurality of WLs, the individual BLs are longitudinally separated from the individual WLs, and the plurality of FTJs longitudinally separate the individual BLs from the individual WLs.

5. The synaptic structure of claims 1-4, wherein the plurality of BLs are perpendicular to the plurality of WLs in a lateral plane.

6. The synaptic structure of claims 1-5, wherein the plurality of BLs are perpendicular to the plurality of WLs in a longitudinal plane.

7. The synaptic structure of claims 1-6, wherein the synaptic structure is configured to perform one or more ANN operations based on an input voltage applied to the plurality of BLs or applied to the plurality of WLs, and when the input voltage is applied to the individual WLs, current is to flow through corresponding FTJs of the plurality of FTJs and is accumulated on the individual BLs.

8. The synaptic structure of claims 1-7, wherein the plurality of BLs comprise copper (Cu), tungsten (W), Ruthenium (Ru), Cobalt (Co), tungsten nitride (WN), titanium nitride (TiN), or a combination thereof, and the plurality of WLs comprise Cu, W, Ru, Co, WN, TiN, or a combination thereof.

9. The synaptic structure of claims 1-8, wherein the plurality of FTJs comprise hafnium oxide ($HfO_2$), hafnium-zirconia ($HfZrO_2$), hafnium zirconium oxide ($Hf_xZr_{1-x}O_2$ ($0.3 \leq x \leq 0.5$)), lead zirconate titanate ($Pb[Zr_xTi_{1-x}]O_3$ ($0 \leq x \leq 1$), barium titanate ($BaTiO_3$), bismuth ferrite ($BiFeO_3$), $Al_xSc_{1-x}N$ ($0.6 \leq x \leq 0.9$), $Al_xSc_{1-x}O_2$ ($0.6 \leq x \leq 0.9$), or combinations thereof.

10. A system, comprising:

    an artificial neural network integrated circuit comprising the synaptic structure of claims 1-9; and
    a processor connected to the artificial neural network integrated circuit to provide data for the artificial neural network integrated circuit.

11. A method of fabricating a synaptic structure for an artificial neural network (ANN) integrated circuit, the method comprising:

    depositing a ferroelectric (FE) material on a wordline (WL) material;
    forming a WL structure including patterning the WL material with the deposited FE material;
    depositing a bitline (BL) material on the FE material; and
    forming a BL structure including patterning the BL material in an opposite direction as the WL structure.

12. The method of claim 11, wherein the forming the WL structure comprises performing lithography and an etching process.

13. The method of claims 11-12, wherein the forming the BL structure comprises performing lithography on the BL material and performing an etching process on the BL material and the FE material.

14. The method of claims 11-13, wherein the depositing the FE material comprises:

    depositing a bottom electrode material on the WL material;
    depositing an active oxide material on the bottom electrode material; and
    depositing a top electrode material on the active oxide material.

15. The method of claims 11-14, further comprising:

    encapsulating the WL structure with a nitride material after forming the WL structure; and
    encapsulating the BL structure with the nitride material or another nitride material after forming the BL structure.

Figure 1

← 200

| | |
|---|---|
| Deposit row (wordline) material | 201 |
| Deposit bottom electrode material | 202 |
| Pattern row (wordline) material | 203 |
| Encapsulate Nitride | 204 |
| Oxide Gap fill | 205 |
| Oxide CMP (stop on metal) | 206 |
| Deposit column (bitline) material | 207 |
| Pattern column (bitline) | 208 |
| Column Etch (stop on bottom W) | 209 |
| Encapsulation Nitride | 210 |

# Figure 2

Figure 3

EP 4 092 749 A1

Figure 4

Figure 5

Figure 6a

EP 4 092 749 A1

Figure 6b

Figure 7a

Figure 7b

Metal Etch:
Subtractive dry etch of CHM and metal layer

Ferroelctric Stack Etch

3- dimensional

Front View

Side View

A  Front View

B  Side View

## Figure 8a

EP 4 092 749 A1

Figure 8b

Figure 9

Figure 10

Figure 11

1200

| Electrode 1201 | Ferroelectric Oxide or Nitride 1210 | Interfacial Layer 1220 | Electrode 1202 |

# Figure 12

Figure 13

Figure 14

Figure 15

Figure 16

EP 4 092 749 A1

Figure 17

EP 4 092 749 A1

EP 4 092 749 A1

1800

Inference Engine 1816

Accelerator(s) 1824

Plurality of synaptic structures
1825

1814 →

← 1818

Application Logic
1812

Model 1820

Hardware Units
1822

Figure 18

**Computing System 1950**

Processor Circuitry 1952

Instructions 1988

Memory Circuitry 1954

Instructions 1982

Storage Circuitry 1958

Logic 1983

Acceleration circuitry 1964

Comm. Circuitry 1966

Input circuitry 1986

Interface Circuitry 1970

Output Ciruitry 1984

Network 1963

External Devices 1972

1956

# Figure 19

<div align="center">

Europäisches
Patentamt

European
Patent Office

Office européen
des brevets

# EUROPEAN SEARCH REPORT

</div>

**Application Number**

**EP 22 15 9470**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/354843 A1 (PARK JAECHUL [KR] ET AL) 21 November 2019 (2019-11-21) | 1-5,7-10 | INV. H01L27/24 |
| Y | * paragraphs [0053] – [0081]; figures 2-5 * | 11-15 | H01L45/00 G06N3/063 |
| X | US 2019/131383 A1 (FRANK MARTIN M [US] ET AL) 2 May 2019 (2019-05-02) * paragraphs [0030] – [0071]; figures 1-19 * | 1,2,4,5, 7-10 | |
| X | BERDAN R ET AL: "Low-power linear computation using nonlinear ferroelectric tunnel junction memristors", NATURE ELECTRONICS, vol. 3, no. 5, May 2020 (2020-05), pages 259-266, XP055964432, DOI: 10.1038/s41928-020-0405-0 * pages 259-260; figures 1a, 1e * | 1,2,4,5, 7,9,10 | |
| X | KR 101 924 733 B1 (POSTECH FOUNDATION [KR]) 3 December 2018 (2018-12-03) * paragraphs [0031] – [0049], [0063] – [0064]; figures 3-5,9 * | 1-3,6,7, 9,10 | **TECHNICAL FIELDS SEARCHED (IPC)** H01L G06N |
| X | CHEN L ET AL: "Ultra-low power Hf0.5Zr0.5O2 based ferroelectric tunnel junction synapses for hardware neural network applications", NANOSCALE, vol. 10, no. 33, 23 July 2018 (2018-07-23) , pages 15826-15833, XP055964442, DOI: 10.1039/C8NR04734K * sections "Introduction", "Experimental"; figure 1 * | 1-3,6,7, 9,10 | |

-/--

The present search report has been drawn up for all claims

| Place of search | Date of completion of the search | Examiner |
|---|---|---|
| Munich | 26 September 2022 | Köpf, Christian |

page 1 of 2

Europäisches
Patentamt

European
Patent Office

Office européen
des brevets

## EUROPEAN SEARCH REPORT

Application Number

EP 22 15 9470

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 382 720 A (TSINGHUA UNIVERSITY) 19 February 2021 (2021-02-19) * paragraphs [0003], [0033] - [0051]; figures 1, 2 * | 1,2,5, 7-10 | |
| Y | US 2016/359109 A1 (KAMIMUTA YUUICHI [JP] ET AL) 8 December 2016 (2016-12-08) * paragraphs [0027] - [0073]; figures 2-10 * | 11-15 | |

TECHNICAL FIELDS
SEARCHED      (IPC)

The present search report has been drawn up for all claims

| Place of search | Date of completion of the search | Examiner |
|---|---|---|
| Munich | 26 September 2022 | Köpf, Christian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 15 9470

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2022

| Patent document cited in search report | | Publication date | Patent family member(s) | | Publication date |
|---|---|---|---|---|---|
| US 2019354843 | A1 | 21-11-2019 | NONE | | |
| US 2019131383 | A1 | 02-05-2019 | US 2019131383 A1 | | 02-05-2019 |
| | | | US 2019326387 A1 | | 24-10-2019 |
| KR 101924733 | B1 | 03-12-2018 | NONE | | |
| CN 112382720 | A | 19-02-2021 | NONE | | |
| US 2016359109 | A1 | 08-12-2016 | JP 6367152 B2 | | 01-08-2018 |
| | | | JP 2017005061 A | | 05-01-2017 |
| | | | US 2016359109 A1 | | 08-12-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Scalability Study on Ferroelectric-HfO2 Tunnel Junction Memory Based on Non-equilibrium Green Function Method. **MO et al.** 2019 19th Non-Volatile Memory Technology Symposium (NVMTS). IEEE, 28 October 2019, 1-5

- **KIM et al.** 4K-memristor analog-grade passive crossbar circuit. *arXiv:1906.12045,* 27 June 2019